# EUROPEAN PATENT SPECIFICATION

(11) **EP 4 407 686 B1**
(45) Date of publication and mention of the grant of the patent: **15.04.2026**
(21) Application number: 24151861.2
(22) Date of filing: 15.01.2024
(51) Int. Cl.: H10F 39/00

(54) **IMAGE SENSOR AND METHOD OF MANUFACTURING THE SAME**
BILDSENSOR UND VERFAHREN ZU SEINER HERSTELLUNG
CAPTEUR D'IMAGE ET SON PROCÉDÉ DE FABRICATION

(30) Priority: 27.01.2023 KR 20230011106; 14.03.2023 KR 20230033475; 03.07.2023 KR 20230085982
(43) Date of publication of application: 31.07.2024
(73) Proprietor: SAMSUNG ELECTRONICS CO., LTD., Yeongtong-gu Suwon-si, Gyeonggi-do 16677 (KR)
(72) Inventor: PARK, Hyeyeon, 16677 Suwon-si, Gyeonggi-do (KR); LEE, Yunki, 16677 Suwon-si, Gyeonggi-do (KR); KIM, Jieun, 16677 Suwon-si, Gyeonggi-do (KR); PARK, Keosung, 16677 Suwon-si, Gyeonggi-do (KR); LIM, Hajin, 16677 Suwon-si, Gyeonggi-do (KR); JEON, Taeksoo, 16677 Suwon-si, Gyeonggi-do (KR); CHOI, Hyunkyu, 16677 Suwon-si, Gyeonggi-do (KR); HUR, Jaesung, 16677 Suwon-si, Gyeonggi-do (KR)
(74) Representative: Kuhnen & Wacker Patent- und Rechtsanwaltsbüro PartG mbB

(56) References cited:
- US-A1- 2015 263 060
- US-A1- 2020 111 923
- US-A1- 2022 115 422
- US-A1- 2022 384 509

## Description

### BACKGROUND

Embodiments of the present disclosure relate to an image sensor, and more particularly, to an image sensor, which includes a grid for separating color filters from each other, and a method of manufacturing the image sensor.

Image sensors are semiconductor devices that may convert optical information into electrical signals. Image sensors may include pixel arrays including a plurality of pixels that are 2-dimensionally arranged. Pixels may each include at least one photodiode. Photodiodes may convert light incident thereon into electrical signals. Pixel arrays may include pixel array areas, which include pixels generating image signals, and light-blocking areas, which include reference pixels generating reference signals that are at dark levels. Image sensors may process image signals by referring to reference signals and thus generate final image signals. Light-blocking areas may include light-blocking films such that light incident on the light-blocking films is blocked and thus not transferred to reference pixels under the light-blocking films.

From US 2020/111923 A1 it is known an integrated chip that has a light sensing element arranged within a substrate. An absorption enhancement structure is arranged along a back-side of the substrate, and an interconnect structure is arranged along a front-side of the substrate. A reflection structure includes a dielectric structure and a plurality of semiconductor pillars that engage the dielectric structure. The dielectric structure and semiconductor pillars are arranged along the front-side of the substrate and are spaced between the light sensing element and the interconnect structure. The plurality of semiconductor pillars and the dielectric structure are collectively configured to reflect incident light that has passed through the absorption enhancement structure and through the light sensing element back towards the light sensing element before the incident light strikes the interconnect structure.

From US 2022/384509 A1 it is known a method that includes forming image sensors in a semiconductor substrate, thinning the semiconductor substrate from a backside of the semiconductor substrate, forming a dielectric layer on the backside of the semiconductor substrate, and forming a polymer grid on the backside of the semiconductor substrate. The polymer grid has a first refractivity value. The method further includes forming color filters in the polymer grid, wherein the color filters have a second refractivity value higher than the first refractivity value, and forming micro-lenses on the color filters.

From US 2022/115422 A1 it is known an image sensor that includes a substrate that includes a plurality of pixel sections and having a first surface and a second surface opposite to each other, an antireflective layer disposed on the second surface of the substrate, a passivation layer disposed on the antireflective layer, a plurality of color filters disposed on the passivation layer and corresponding pixel sections, a plurality of micro-lenses disposed on the color filters, and a gap region that separates the micro-lenses from each other. The gap region extends between the color filters and separates the color filters from each other. The gap region exposes a portion of a top surface of the passivation layer. A thickness of the passivation layer is less than a thickness of the antireflective layer.

### SUMMARY

One or more embodiments provide an image sensor, which may exhibit improved quantum efficiency (QE) and improve stain defects, and a method of manufacturing the image sensor.

An image sensor according to the invention is defined by independent claim 1 and a method of manufacturing an image sensor according to the invention is defined by independent claim 9. Further developments of the image sensor and/or the method are defined by the dependent claims.

In addition, embodiments are not limited to the aspects set forth above, and the above and other aspects of embodiments will be clearly understood by those of ordinary skill in the art from the following detailed description.

### BRIEF DESCRIPTION OF THE DRAWINGS

Embodiments will be more clearly understood from the following detailed description taken in conjunction with the accompanying drawings in which:
FIG. 1 is a block diagram of an image sensor according to an embodiment;
FIG. 2 is a perspective view of the image sensor of FIG. 1, more particularly, an exploded perspective view illustrating a first semiconductor chip and a second semiconductor chip separately from each other;
FIG. 3 is an equivalent circuit diagram of some unit pixels in a pixel area of the image sensor of FIG. 1;
FIG. 4 is a plan view of the image sensor of FIG. 1;
FIG. 5 is a cross-sectional view of the image sensor of FIG. 1, taken along a line I-I' of FIG. 4;
FIG. 6A is a graph illustrating an extinction coefficient (that is, κ) of TiN along with wavelengths, and FIG. 6B a graph illustrating quantum efficiency (QE) for each type of grid pattern along with wavelengths;
FIGS. 7A and 7B are conceptual diagrams illustrating the loss and improvement of QE in an image sensor of a related example and an image sensor according to an embodiment, respectively;
FIGS. 8A and 8B are cross-sectional views illustrating grid pattern structures of an image sensor of a related example and an image sensor according to an embodiment, respectively;
FIG. 9A is an enlarged cross-sectional view of a region A1 of FIG. 8A, FIG. 9B is an enlarged cross-sectional view of a region A2 of FIG. 8B, and FIG. 9C is a cross-sectional view illustrating an anti-reflective layer of a node isolation portion of an image sensor according to an embodiment;
FIGS. 10A, 10B, 11A, 11B, 12A, and 12B illustrate plan views of node isolation portions of the anti-reflective layer of FIG. 9C at various positions in the image sensor of FIG. 1 and cross-sectional views corresponding thereto;
FIGS. 13A, 13B, 13C, 13D, 13E, 13F, 13G, 13H, 13I, 13J, and 13K are cross-sectional views respectively illustrating a sequence of processes of a method of manufacturing an image sensor, according to an embodiment; and
FIGS. 14A and 14B are cross-sectional views illustrating processes of forming a grid pattern in an image sensor of a related example and an image sensor according to an embodiment, respectively.

### DETAILED DESCRIPTION OF THE EMBODIMENTS

Hereinafter, embodiments will be described in detail with reference to the accompanying drawings. Like components are denoted by like reference numerals throughout the specification, and repeated descriptions thereof are omitted.

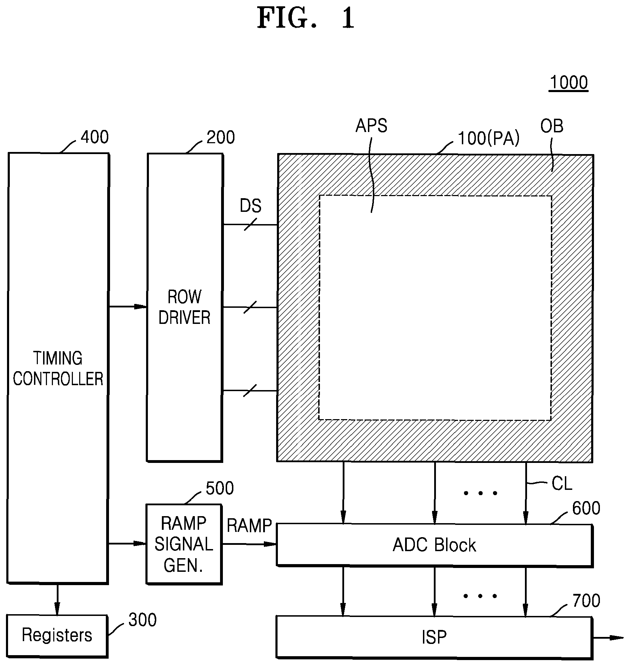

FIG. 1 is a block diagram of an image sensor according to an embodiment.

Referring to FIG. 1, an image sensor 1000 may include a pixel area 100 (or PA), a row driver 200, a mode setting register 300, a timing controller 400, a ramp signal generator 500, an analog-to-digital converter (ADC) block 600, and a signal processor 700.

The pixel area 100 may include a pixel array region APS and a light-blocking region OB. As shown in FIG. 1, the pixel array region APS may be arranged in a central portion of the pixel area 100, and the light-blocking region OB may be arranged in an peripheral portion of the pixel area 100 to be provided adjacent to and surround the pixel array region APS. For example, the pixel array region APS may be referred to as an active pixel sensor region and the light-blocking region OB may be referred to as an optical black pixel region. Each of the pixel array region APS and the light-blocking region OB may include a plurality of unit pixels that are 2-dimensionally arranged. A unit pixel may convert an optical signal into an electrical signal. The unit pixels of the pixel area 100 may each output an electrical signal through a column line CL corresponding thereto in response to a plurality of driving signals DS, such as a pixel select signal, a reset signal, and a charge transmission signal, from the row driver 200 on a row basis.

The row driver 200 may select and drive the unit pixels of the pixel area 100 on a row basis. The row driver 200 may decode a row control signal (for example, an address signal) received from the timing controller 400 and may generate a plurality of driving signals DS corresponding to a decoded row line to transmit the plurality of driving signals DS to the pixel area 100.

The mode setting register 300 may correspond to a register for an application processor (AP), which is connected with the image sensor 1000, to set an operation mode of the image sensor 1000 through an interface. The AP may change an operation condition of the image sensor 1000 on a frame basis through the mode setting register 300.

The timing controller 400 may collectively control operations of circuit blocks (that is, 200, 400, and 500) of the image sensor 1000 according to mode setting information that is set in the mode setting register 300.

The ramp signal generator 500 may generate a ramp signal RAMP, which increases or decreases with a certain slope, and may provide the ramp signal RAMP to the ADC block 600.

The ADC block 600 may convert analog electrical signals, which are output from column lines CL of the pixel area 100, into digital image signals by a correlated double sampling (CDS) method. The CDS method may allow a noise level and a signal level of a unit pixel, which are transferred to a column line, to be double-sampled and allow a difference level corresponding to the difference between the noise level and the signal level to be converted and generated into a digital image signal.

The signal processor 700 may process a received image signal and thus output a final image signal. The signal processing of the signal processor 700 may include noise reduction, gain adjustment, waveform normalization, interpolation, white balancing, gamma processing, edge enhancement, binning, and the like.

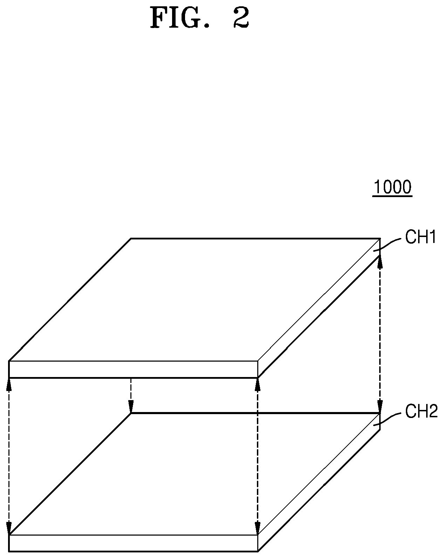

FIG. 2 is a perspective view of the image sensor 1000 of FIG. 1, more particularly, an exploded perspective view illustrating a first semiconductor chip and a second semiconductor chip separate from each other. Descriptions are made with reference to FIG. 2 together with FIG. 1, and the descriptions already given with reference to FIG. 1 are made briefly or omitted.

Referring to FIG. 2, the image sensor 1000 according to an embodiment may include two semiconductor chips (that is, CH1 and CH2). The pixel area 100 of the image sensor 1000 of FIG. 1 may be arranged in a first semiconductor chip CH1. All circuit blocks (that is, 200 to 700) except for the pixel area 100 of the image sensor 1000 of FIG. 1 may be arranged in a second semiconductor chip CH2. The first semiconductor chip CH1 and the second semiconductor chip CH2 may be stacked to vertically overlap each other. The first semiconductor chip CH1 and the second semiconductor chip CH2 may transmit signals to each other through a wiring layer of each thereof and a through-silicon via (TSV), which passes through the first semiconductor chip CH1, or an inter-chip connection terminal.

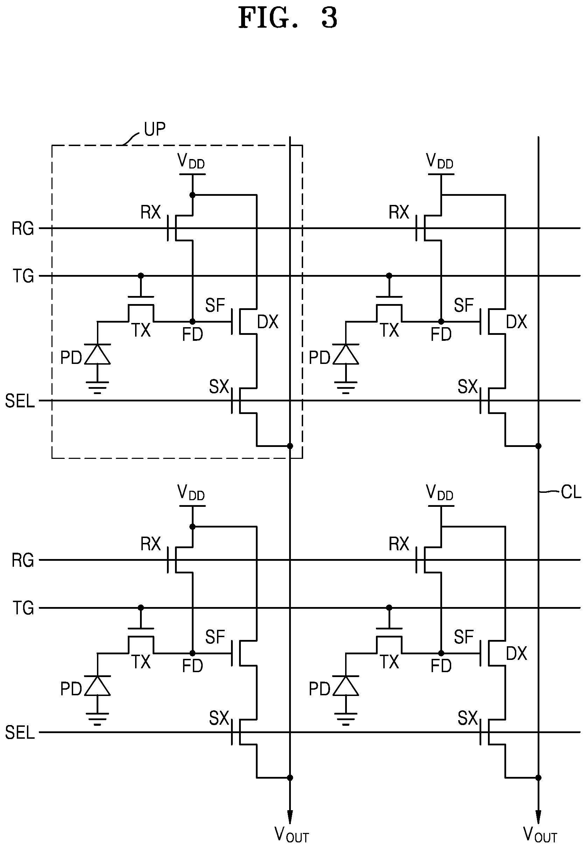

In an embodiment, the image sensor 1000 may include three semiconductor chips that are stacked. When the image sensor 1000 includes three semiconductor chips that are stacked, the pixel area 100 may be formed in the uppermost first semiconductor chip, and here, some of the components constituting the unit pixel may be arranged in the first semiconductor chip. For example, in the first semiconductor chip, a photodiode (see PD of FIG. 3), a transmission transistor (see TX of FIG. 3), and a floating diffusion region (see FD of FIG. 3), which constitute the unit pixel, may be arranged. The pixel area 100 may also be formed in a second semiconductor chip located under the first semiconductor chip, and here, pixel transistors except for the transmission transistor TX, for example, a reset transistor (see RX of FIG. 3), a source follower transistor (see DX of FIG. 3), and a select transistor (see SX of FIG. 3), may be arranged in the second semiconductor chip. The transmission transistor TX and the floating diffusion region FD in the first semiconductor chip may be connected with the pixel transistors (that is, RX, DX, and SX) corresponding thereto in the second semiconductor chip through a TSV, an inter-chip connection terminal, or the like. In a third semiconductor chip located under the second semiconductor chip, the circuit blocks (that is, 200 to 700) except for the pixel area 100 may be arranged. The third semiconductor chip may be connected with the second semiconductor chip through a TSV, an inter-chip connection terminal, or the like.

FIG. 3 is a circuit diagram of some unit pixels in the pixel area 100 of the image sensor 1000 of FIG. 1. Descriptions are made with reference to FIG. 3 together with FIG. 1, and the descriptions already given with reference to FIGS. 1 and 2 are made briefly or omitted.

Referring to FIG. 3, the pixel area 100 may include a plurality of unit pixels UP, and the unit pixels UP may be arranged in a 2-dimensional array structure. A unit pixel UP may include a photodiode PD and pixel transistors. The pixel transistors may include a transmission transistor TX, a reset transistor RX, a source follower transistor DX, and a select transistor SX. In addition, the unit pixel UP may include a floating diffusion region FD, which is connected to a source or a drain of each of the transmission transistor TX and the reset transistor RX and connected to a gate of the source follower transistor DX.

The photodiode PD may generate and accumulate charges in proportion to the amount of light incident from outside thereof during an exposure time period. In the image sensor 1000 according to an embodiment, a phototransistor, a photogate, a pinned photodiode, or the like may be arranged instead of the photodiode PD. As such, devices converting light into charges are referred to as photoelectric conversion devices.

The transmission transistor TX may transmit the charges accumulated in the photodiode PD during the exposure time period to the floating diffusion region FD in response to a transmission control signal TG. The charges transmitted from the photodiode PD via the transmission transistor TX may be stored in the floating diffusion region FD. The voltage of the gate of the source follower transistor DX may be determined depending on the amount of charges stored in the floating diffusion region FD.

The reset transistor RX may reset the charges stored in the floating diffusion region FD. The source of the reset transistor RX may be connected with the floating diffusion region FD, and the drain of the reset transistor RX may be connected to a power supply voltage V_{DD}. When the reset transistor RX is turned on by a reset control signal RG, the power supply voltage V_{DD} of the drain of the reset transistor RX may be applied to the floating diffusion region FD and the charges may be released. Therefore, when the reset transistor RX is turned on, all the charges stored in the floating diffusion region FD may be released and the voltage of the floating diffusion region FD may be reset to the power supply voltage V_{DD}.

The source follower transistor DX may include a gate connected to the floating diffusion region FD, a drain connected to the power supply voltage V_{DD}, and a source connected to the select transistor SX. The source follower transistor DX may function as a source follower buffer amplifier, which generates an output voltage in a source thereof in response to the voltage of a gate thereof.

The select transistor SX may transfer the output voltage to the source of the source follower transistor DX to a column line CL in response to a column select signal SEL. For example, the source follower transistor DX and the select transistor SX may sense a voltage change of the floating diffusion region FD and thus output an output voltage Vout to the column line CL.

In the unit pixel UP of FIG. 3, one floating diffusion region FD and the pixel transistors (that is, RX, DX, and SX) corresponding thereto may be arranged one-to-one in one photodiode PD. However, a unit pixel constituting a high-resolution image sensor may have a shared pixel structure in which a plurality of photodiodes PD share one floating diffusion region FD and the pixel transistors (that is, RX, DX, and SX) corresponding thereto.

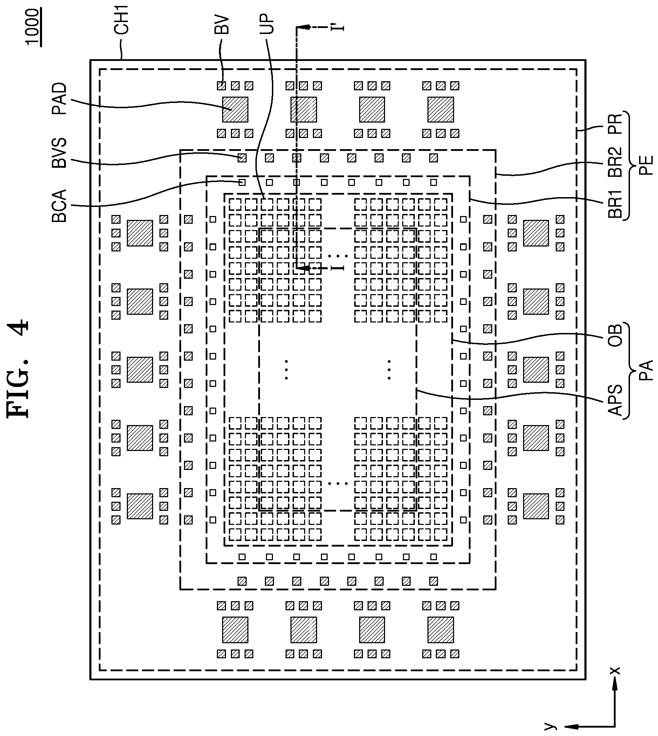

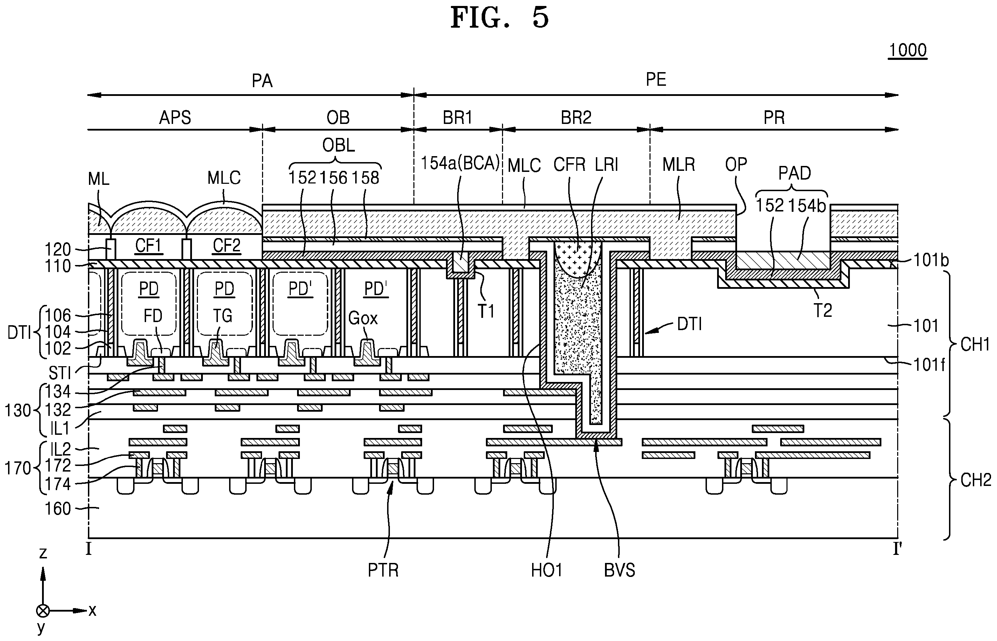

FIG. 4 is a plan view of the image sensor 1000 of FIG. 1, and FIG. 5 is a cross-sectional view of the image sensor 1000, taken along a line I-I' of FIG. 4. Descriptions are made with reference to FIGS. 4 and 5 together with FIG. 1, and the descriptions already given with reference to FIGS. 1 to 3 are made briefly or omitted.

Referring to FIGS. 4 and 5, the image sensor 1000 according to an embodiment may include the first semiconductor chip CH1 and the second semiconductor chip CH2. In the image sensor 1000 according to an embodiment, for example, the first semiconductor chip CH1 may be stacked on the second semiconductor chip CH2.

The first semiconductor chip CH1 may include a first substrate 101. The first substrate 101 may include silicon (Si). The first substrate 101 may include, for example, a silicon single-crystal substrate, a silicon epitaxial-layer substrate, or a silicon-on-insulator (SOI) substrate. However, the material of the first substrate 101 is not limited to Si. For example, the first substrate 101 may include another single-element semiconductor, such as germanium (Ge), or a compound semiconductor, such as silicon carbide (SiC), gallium arsenide (GaAs), indium arsenide (InAs), or indium phosphide (InP). The first substrate 101 may be doped with, for example, an impurity of a first conductivity type. Here, the first conductivity type may be P-type. However, the first conductivity type is not limited to P-type. The first substrate 101 may include a front surface 101f and a back surface 101b, which are opposite to each other. Here, the front surface 101f may correspond to an active surface and the back surface 101b may correspond to an inactive surface.

In a plan view of the first semiconductor chip CH1, the image sensor 1000 may include a pixel area PA and a peripheral area PE. As described with reference to FIG. 1, the pixel area PA may include a pixel array region APS and a light-blocking region OB. A plurality of unit pixels UP may be formed in the first substrate 101 in the pixel array region APS and the light-blocking region OB. As shown in FIG. 4, the light-blocking region OB may surround the pixel array region APS. For example, although FIG. 4 illustrates that the pixel array region APS is centrally located with a small area and each of the light-blocking region OB and the peripheral area PE has a relatively large area, embodiments are not limited thereto. In the image sensor 1000 according to an embodiment, the pixel array region APS may occupy most of the first semiconductor chip CH1, and the light-blocking region OB and the peripheral area PE may each be arranged with in a relatively small area outside the pixel array region APS.

The peripheral area PE may be adjacent to and surround the pixel area PA, that is, the light-blocking region OB. The peripheral area PE may include, for example, a contact region BR1, a backside via stack region BR2, and a pad region PR. The contact region BR1 may be arranged adjacent to the light-blocking region OB. In the contact region BR1, backside contacts BCA may be arranged linearly with certain intervals along a line surrounding the light-blocking region OB.

The backside via stack region BR2 may be located between the contact region BR1 and the pad region PR. Backside via stacks BVS may be arranged in the backside via stack region BR2. In FIG. 4, the backside via stacks BVS are arranged in a line to be provided adjacent to and surround the contact region BR1. However, embodiments are not limited thereto, and the backside via stacks BVS may be arranged in a 2-dimensional array structure in the backside via stack region BR2. In addition, although the backside via stacks BVS are arranged adjacent to all sides of the contact region BR1, embodiments are not limited thereto, and the backside via stacks BVS may not be arranged on at least one side of the contact region BR1. According to some embodiments, a shield region may be defined between the contact region BR1 and the pad region PR, and the backside via stack region BR2 may be arranged in a portion of the shield region.

The pad region PR may be located in the outermost portion of the peripheral area PE. Backside vias BV and pads PAD may be arranged in the pad region PR. Although FIG. 4 illustrates that the pad region PR has a large area, this is exaggerated to illustrate an arrangement structure of the pads PAD and the backside vias BV therearound. According to some embodiments, a chip edge region may be arranged outside the pad region PR. In addition, a portion of a scribe lane may remain in the chip edge region.

A pixel isolation unit DTI (deep trench isolation (DTI)) may be formed in the first substrate 101 in the pixel array region APS and the light-blocking region OB and thus isolate the unit pixels UP from each other. As shown in FIG. 5, the pixel isolation unit DTI may also be formed in the contact region BR1 and the backside via stack region BR2 of the peripheral area PE. The pixel isolation unit DTI may have a mesh shape in a plan view. The pixel isolation unit DTI may have a structure passing through the first substrate 101 in the z direction. Because the pixel isolation unit DTI has a structure passing through the first substrate 101, crosstalk due to obliquely incident light may be prevented.

The pixel isolation unit DTI may have a front DTI (FDTI) structure extending from the front surface 101f to the back surface 101b of the first substrate 101. According to some embodiments, the pixel isolation unit DTI may have a back DTI (BDTI) structure extending from the back surface 101b to the front surface 101f of the first substrate 101. For example, each of the FDTI structure and the BDTI structure may be identified depending on which of the width thereof at the front surface 101f and the width thereof at the back surface 101b is larger. That is, the pixel isolation unit DTI may be formed by forming a trench in the first substrate 101 and then filling the inside of the trench with an insulating material and a conductive material. Therefore, in the case of the FDTI structure obtained by digging a trench from the front surface 101f of the first substrate 101, the width of the trench at the front surface 101f of the first substrate 101 may be greater than the width of the trench at the back surface 101b of the first substrate 101. In the case of the BDTI structure obtained by digging a trench from the back surface 101b of the first substrate 101, the width of the trench at the back surface 101b of the first substrate 101 may be greater than the width of the trench at the front surface 101f of the first substrate 101.

The pixel isolation unit DTI may include an insulating pattern 102, a side insulating layer 104, and a conductive pattern 106. The insulating pattern 102 may be arranged between the conductive pattern 106 and a first interlayer dielectric IL1. The side insulating layer 104 may be arranged between the conductive pattern 106 and the first substrate 101 and between the insulating pattern 102 and the first substrate 101. The side insulating layer 104 may surround a peripheral portion of the conductive pattern 106 and insulate the conductive pattern 106 from the first substrate 101. The side insulating layer 104 may include, for example, silicon oxide, silicon nitride, silicon oxynitride, or the like.

Each of the insulating pattern 102 and the side insulating layer 104 may include an insulating material having a different refractive index from the first substrate 101. Each of the insulating pattern 102 and the side insulating layer 104 may include, for example, silicon oxide. The conductive pattern 106 may be separated from the first substrate 101 by the side insulating layer 104. The conductive pattern 106 may include polysilicon or silicon germanium, which is doped with an impurity. The impurity doped into polysilicon or silicon germanium may include, for example, one of boron, phosphorus, and arsenic. According to some embodiments, the conductive pattern 106 may include a metal, a metal silicide, a metal-containing conductive material, or the like.

The photodiode PD may be doped with an impurity of a second conductivity type that is opposite to the first conductivity type. For example, the second conductivity type may be N-type. A region doped with an N-type impurity, together with the first substrate 101 located therearound and doped with a P-type impurity, may form a PN junction and thus constitute the photodiode PD.

A device isolation unit STI (a shallow trench isolation (STI)) may be arranged adjacent to the front surface 101f of the first substrate 101. The device isolation unit STI may be pierced by the pixel isolation unit DTI. In some embodiments, the pixel isolation unit DTI may be in contact with the device isolation unit STI. Active regions may be defined in the unit pixel UP by the device isolation unit STI. In the active regions, transistors (that is, TX, RX, DX, and SX) of the unit pixel UP may be arranged.

A transmission gate TG of the transmission transistor TX of the unit pixel UP may be arranged on the front surface 101f of the first substrate 101. The transmission gate TG may have a vertical gate structure in which a portion of the transmission gate TG extends to the inside of the first substrate 101. However, according to some embodiments, the transmission gate TG may have a planar gate structure in which the transmission gate TG is arranged only on the front surface 101f of the first substrate 101. A gate insulating film Gox may be arranged between the transmission gate TG and the first substrate 101. The floating diffusion region FD may be arranged in the first substrate 101 on one side of the transmission gate TG. The floating diffusion region FD may be doped with, for example, an impurity of the second conductivity type.

The image sensor 1000 according to an embodiment may include an image sensor having a backside illumination (BSI) structure. The BSI structure may refer to a structure in which a color filter CF and a micro-lens ML are arranged on or over the back surface 101b of the first substrate 101 and a first wiring layer 130 is arranged on the front surface 101f of the first substrate 101. Therefore, in the image sensor 1000 according to an embodiment, light may be incident on the photodiode PD of the pixel array region APS through the back surface 101b of the first substrate 101. Electron-hole pairs may be generated in the photodiode PD by light incident on the photodiode PD, and thus, electrons may be accumulated in the photodiode PD. When the transmission transistor TX is turned on, the electrons accumulated in the photodiode PD may move to the floating diffusion region FD. For reference, there is a frontside illumination (FSI) structure that is opposite to the BSI structure, and the FSI structure may refer to a structure in which all the color filter CF, the micro-lens ML, and the first wiring layer 130 are arranged on or over the front surface 101f of the first substrate 101.

The first semiconductor chip CH1 may include the first wiring layer 130 arranged on the front surface 101f of the first substrate 101. The first wiring layer 130 may include the first interlayer dielectric IL1, a first wiring line 132, and a first via contact 134. The first interlayer dielectric IL1 may include at least one of silicon oxide, silicon nitride, silicon oxynitride, and a porous low-k material and may have a multilayered structure. The first wiring line 132 may be arranged in the first interlayer dielectric IL1. The first wiring line 132 may have a multilayered structure in correspondence with the multilayered structure of the first interlayer dielectric IL1. First wiring lines 132 in different layers may be connected with each other by the first via contact 134 passing through at least a portion of the first interlayer dielectric IL1. In addition, the first wiring line 132 may be connected to the floating diffusion region FD and the transmission gate TG through the first via contact 134.

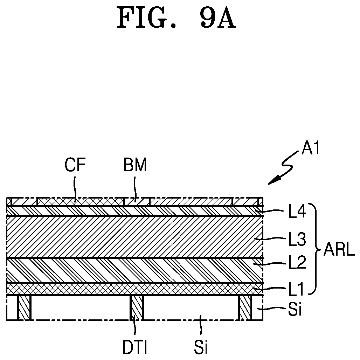

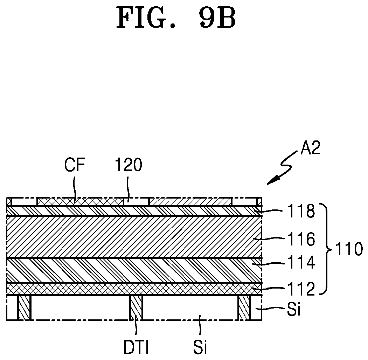

An anti-reflective layer 110 may be arranged on the back surface 101b of the first substrate 101. The anti-reflective layer 110 may be arranged in the entire portions of the pixel area PA and the peripheral area PE. However, embodiments are not limited thereto, and the anti-reflective layer 110 may not be arranged on the backside contact BCA, the backside via stack BVS, and the backside via BV. The anti-reflective layer 110 may have a multilayered structure and may include a TiO₂ layer (see 114 of FIG. 9B). The anti-reflective layer 110 may suppress the reflection of incident light and increase the amount of light incident on the photodiode PD, depending on the thickness and refractive index of each layer thereof. In the image sensor 1000 according to an embodiment, the anti-reflective layer 110 includes the TiO₂ layer 114, thereby preventing a stain defect that may be generated because a grid pattern 120 does not include a metal layer. The multilayered structure of the anti-reflective layer 110 is described below in more detail with reference to FIGS. 9A to 9C.

The grid pattern 120 may be arranged on the anti-reflective layer 110 of the pixel array region APS. The grid pattern 120 may have a mesh shape in a plan view and may vertically overlap the pixel isolation unit DTI. The grid pattern 120 may have a uniform width and a uniform thickness and may include an organic or inorganic material having a relatively low refractive index. Here, the width may refer to a width in the x direction or the y direction, and the thickness may refer to a thickness in the z direction. In the image sensor 1000 according to an embodiment, the grid pattern 120 may have a low refractive index. For example, the grid pattern 120 may have a refractive index of 1.3 or less. However, the refractive index of the grid pattern 120 is not limited to the above range of numerical values. In the image sensor 1000 according to an embodiment, the grid pattern 120 may include tetraethyl orthosilicate (TEOS), PTEOS, or a porous low-k material. For example, TEOS may be formed at 400 °C or less by a plasma process. As such, TEOS formed by a plasma process is referred to as PE-TEOS or PTEOS.

For example, a relatively low refractive index and a relatively high refractive index may be determined based on a refractive index of 1.5 or so. For example, TiO₂, which is known as having a highest refractive index from among metal oxides, may have an extremely high refractive index of 2.5 (in an anatase crystal structure) or 2.7 (in a rutile crystal structure). MgF₂ may have a low refractive index of about 1.38. In addition, MgF₂ may have a decreasing refractive index due to a more porous structure thereof as an oblique incidence angle thereon increases and may have an extremely low refractive index of about 1.2 at an oblique incidence angle of 80°.

The grid pattern 120 may include a single-insulating-layer structure. However, embodiments are not limited thereto, and the grid pattern 120 may include a multi-insulating-layer structure. In the image sensor 1000 according to an embodiment, the grid pattern 120 may not include a metal layer, such as Ti/TiN. As such, the grid pattern 120 does not include a metal layer, thereby preventing the loss of quantum efficiency (QE) due to light absorption of a metal layer. Therefore, the QE of the image sensor 1000 may improve.

Color filters CF1 and CF2 may be respectively arranged inside grids of the grid pattern 120 on the anti-reflective layer 110. For example, the color filters CF1 and CF2 may be isolated from each other by the grid pattern 120. Each of the color filters CF1 and CF2 may have, for example, one color from among blue, green, and red. In an embodiment, each of the color filters CF1 and CF2 may have a color combination, such as cyan, magenta, or yellow. In the image sensor 1000 according to an embodiment, the color filters CF1 and CF2 may be arranged in a Bayer pattern form. However, embodiments are not limited thereto, and the color filters CF1 and CF2 may be arranged in the form of a tetra pattern with a 2x2 array, a nona pattern with a 3x3 array, or a hexadeca pattern with a 4x4 array. The grid pattern 120 may have a refractive index that is less than that of each of the color filters CF1 and CF2. For example, the grid pattern 120 may have a refractive index of 1.3 or less. The grid pattern 120 may prevent crosstalk between adjacent unit pixels UP.

A light-blocking layer OBL may be arranged on the anti-reflective layer 110 of the light-blocking region OB of the first substrate 101. The light-blocking layer OBL may block light from being incident on photodiodes PD' of reference pixels formed in the first substrate 101 in the light-blocking region OB. Each of the photodiodes PD' of the reference pixels may have the same structure as the photodiode PD formed in the pixel array region APS but may not perform the same operation (that is, an operation of generating electrical signals according to the amount of light incident thereon) as the photodiode PD. For example, due to the photodiodes PD' of the reference pixels being blocked from light, the photodiodes PD' of the reference pixels may each generate a dark level reference signal. The signal processor 700 of FIG. 1 may compensate for dark levels of output values of the pixels of the pixel array region APS by using the dark level reference signal.

The light-blocking layer OBL may include a first conductive layer 152, a first insulating layer 156, and a second insulating layer 158. In addition, According to some embodiments, the light-blocking layer OBL may further include an additional conductive layer between the first insulating layer 156 and the second insulating layer 158. A portion of light incident on the light-blocking layer OBL may pass through the first insulating layer 156 and the second insulating layer 158, and may be reflected or absorbed by the first conductive layer 152. A portion of the light reflected by the first conductive layer 152 may be absorbed by the first insulating layer 156. In addition, when the additional conductive layer is provided, the remaining portion of the light may be absorbed by the additional conductive layer. The first conductive layer 152 may absorb energy of light in visible and near-infrared bands due to a plasmon phenomenon at the surface of the first conductive layer 152. As light reflected by light-blocking region OB is further minimized, the quality deterioration of an image signal due to a flare phenomenon, which may occur in the image sensor 1000, may be further prevented.

The light-blocking layer OBL may be arranged on the anti-reflective layer 110. A barrier metal layer for adhesion improvement may be further arranged between the light-blocking layer OBL and the anti-reflective layer 110. The barrier metal layer may include, for example, titanium (Ti) and/or titanium nitride (TiN). The first conductive layer 152 may have a relatively high thickness, for example, a thickness of 100 nm or more, to minimize the transmittance of light incident thereon. The first conductive layer 152 may include a metal, such as tungsten (W). The thickness of the first insulating layer 156 may be determined depending on the wavelength of light to be absorbed. For example, when the image sensor 1000 is a device using RGB visible light, the thickness of the first insulating layer 156 may be less than the thickness of the first insulating layer 156 of a device using infrared light. The first insulating layer 156 may include, for example, silicon oxide. The second insulating layer 158 may function as an anti-reflective layer. Therefore, the second insulating layer 158 may be formed to a thickness that is less than or equal to a thickness corresponding to 1/4 of the wavelength of light intended to be absorbed. According to some embodiments, the second insulating layer 158 may be formed in a multilayered structure and may include hafnium oxide (HfOx). The materials, thicknesses, or the like of the first conductive layer 152, the first insulating layer 156, and the second insulating layer 158 are not limited to the materials or numerical values set forth above and may be variously changed according to some embodiments.

The height of the light-blocking layer OBL from the anti-reflective layer 110 may be substantially equal to or less than the height of each of the color filters CF1 and CF2 from the anti-reflective layer 110 in the pixel array region APS. A step height between the light-blocking layer OBL and each of the color filters CF1 and CF2, on the back surface 101b of the first substrate 101, may be minimized, thereby improving defects in subsequent processes, such as a process of forming the micro-lens ML.

Backside contacts BCA may be arranged in the contact region BR1. The backside contact BCA may pass through the anti-reflective layer 110 and may be arranged in a first trench T1 of the first substrate 101. The backside contact BCA may include the first conductive layer 152 and a first metal pattern 154a. A barrier metal layer may be further arranged under the first conductive layer 152. The first conductive layer 152 and the barrier metal layer may uniformly cover a side surface and a bottom surface of the first trench T1. The first metal pattern 154a may include, for example, aluminum (Al). However, the material of the first metal pattern 154a is not limited to Al. The first metal pattern 154a may fill the first trench T1. The backside contact BCA may be connected to the conductive pattern 106 of the pixel isolation unit DTI. The backside contact BCA may receive a certain voltage, for example, a ground voltage or a negative voltage, applied thereto through the first conductive layer 152 and may apply the voltage to the conductive pattern 106 of the pixel isolation unit DTI. As such, because a ground or negative voltage is applied to the conductive pattern 106 of the pixel isolation unit DTI through the backside contact BCA, holes (that is, positive holes), which may be present at the surface of the side insulating layer 104 of the pixel isolation unit DTI, may be fixed, thereby improving dark current characteristics.

The backside via stacks BVS may be arranged in the backside via stack region BR2. The backside via stack BVS may be arranged in a first hole HO1. The backside via stack BVS may extend in the z direction with a structure passing through the anti-reflective layer 110, the first substrate 101, and the first interlayer dielectric IL1 and partially passing through a second interlayer dielectric IL2. In the backside via stack BVS, the first conductive layer 152 and the first insulating layer 156 of the light-blocking layer OBL may uniformly cover a sidewall and a bottom surface of the first hole HO1. The backside via stack BVS may electrically connect some of the first wiring lines 132 of the first semiconductor chip CH1 with some of the second wiring lines 172 of the second semiconductor chip CH2. First holes HO1 may each be filled with a protective pattern LRI. The protective pattern LRI may include a low-refractive-index material layer. In addition, a capping pattern CFR may be arranged on the protective pattern LRI.

A pad PAD may be arranged in the pad region PR. The pad PAD may be arranged in a second trench T2. The pad PAD may include the first conductive layer 152 and a second metal pattern 154b. For example, the anti-reflective layer 110 may be arranged on a sidewall and a bottom surface of the second trench T2. The first conductive layer 152 may uniformly cover the anti-reflective layer 110 in the second trench T2. The second metal pattern 154b may be arranged on the first conductive layer 152 and may fill the second trench T2. The second metal pattern 154b may include, for example, Al. However, the material of the second metal pattern 154b is not limited to Al.

As can be seen through FIG. 4, the backside vias BV may be arranged around the pad PAD. Similar to the backside via stack BVS, the backside via BV may pass through the anti-reflective layer 110, the first substrate 101, and the first interlayer dielectric IL1 and partially pass through the second interlayer dielectric IL2. The backside via BV may not be connected to the first wiring lines 132 and may be connected to some of the second wiring lines 172. The backside via BV may be connected with the pad PAD corresponding thereto through the first conductive layer 152. That is, signals, which are input from outside the image sensor 1000 or output from the image sensor 1000, may be interfaced by the backside via BV and the pad PAD.

Micro-lenses ML may be respectively arranged on the color filters CF1 and CF2 of the pixel array region APS. Edge portions of the micro-lenses ML may be in contact with and connected with each other. The micro-lenses ML may constitute an array. Therefore, the micro-lenses ML may form a micro-lens array. One micro-lens ML may cover and correspond to one pixel. However, in some embodiments, one micro-lens ML may cover a plurality of pixels all together. For example, when a plurality of pixels constitute one shared pixel, one micro-lens ML may cover the entire shared pixel.

A lens remaining layer MLR may be arranged on the light-blocking layer OBL of the peripheral area PE. The lens remaining layer MLR may include the same material as the micro-lenses ML. A lens coating layer MLC may cover the micro-lens ML and the lens remaining layer MLR. In the pad region PR, an opening OP may be formed through the lens remaining layer MLR and the lens coating layer MLC to expose the pad PAD.

The second semiconductor chip CH2 may include a second substrate 160 and a second wiring layer 170. The second semiconductor chip CH2 may be arranged under the first semiconductor chip CH1, and the second wiring layer 170 of the second semiconductor chip CH2 may be connected to the first wiring layer 130 of the first semiconductor chip CH1. Transistors PTR for logic devices may be arranged in an upper portion of the second substrate 160. The transistors PTR for logic devices may constitute the circuit blocks (that is, 200 to 700) of the image sensor 1000. In the second semiconductor chip CH2, an upper surface of the second substrate 160 may correspond to a front surface thereof that is an active surface. The second wiring layer 170 may be arranged on the second substrate 160 and the transistors PTR. The second wiring layer 170 may include the second interlayer dielectric IL2, the second wiring line 172, and a second via contact 174. The second interlayer dielectric IL2, the second wiring line 172, and the second via contact 174 are the same as described regarding the first interlayer dielectric IL1, the first wiring line 132, and the first via contact 134 of the first wiring layer 130, respectively.

In the image sensor 1000 according to an embodiment, the grid pattern 120 may not include a metal layer, such as Ti/TiN or the like. For example, the grid pattern 120 may include only a single insulating layer having a relatively low refractive index. Therefore, the image sensor 1000 according to an embodiment may prevent QE loss due to light absorption of a metal layer and thus exhibit improved QE. In addition, in the image sensor 1000 according to an embodiment, the anti-reflective layer 110 arranged under the color filters CF1 and CF2 and the grid pattern 120 may include the TiO₂ layer 114, and the TiO₂ layer 114 may function as a charge path. Therefore, the image sensor 1000 according to an embodiment may prevent a stain defect that may be generated because the grid pattern 120 does not include a metal layer.

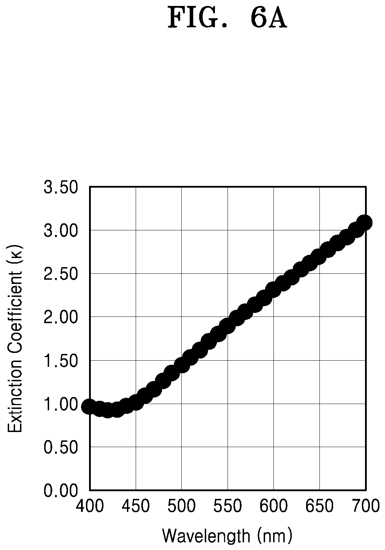

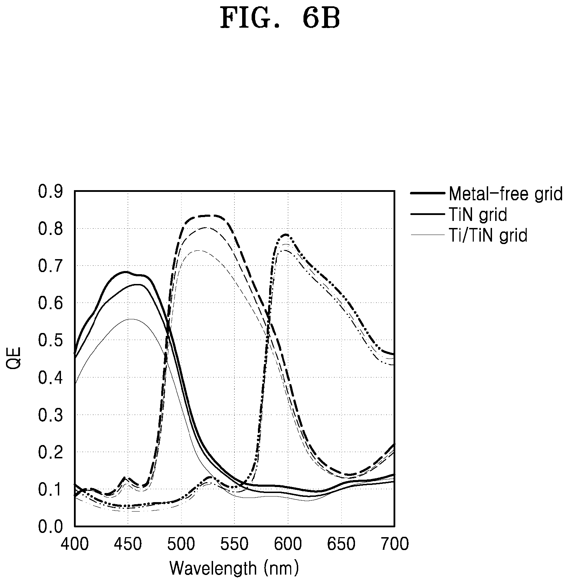

FIG. 6A is a graph illustrating an extinction coefficient (that is, κ) of TiN along with wavelengths, and FIG. 6B is a graph illustrating QE for each type of grid pattern along with wavelengths.

Referring to FIG. 6A, in the case of TiN that is mainly used for a barrier metal layer, the extinction coefficient (that is, κ) thereof may increase with an increasing wavelength. Therefore, when TiN is included as a barrier metal layer in a grid pattern, QE loss due to the grid pattern may be generated, and in particular, there may be significant QE loss in long wavelengths.

Referring to FIG. 6B, QE along with wavelengths is illustrated for a structure in which a grid pattern does not include a metal layer (that is, a metal-free grid), a structure in which a grid pattern includes a barrier metal layer including TiN (that is, a TiN grid), and a structure in which a grid pattern includes a barrier metal layer including Ti/TiN. In addition, the solid lines show QE for blue filters, the dashed lines show QE for green filters, and the dash-double dotted lines show QE for red filters.

As can be seen through the graph in FIG. 6B, the metal-free grid shows the highest QE throughout the wavelengths. Specifically, in the case of a blue filter, the QE of the metal-free grid may be highest in blue-based short wavelengths in which the QE thereof is maintained high and may also be highest in medium wavelengths and long wavelengths in which the QE thereof is maintained low. These results are the same for a green filter and a red filter. In conclusion, it may be anticipated that the QE of an image sensor may be improved by forming a grid pattern not including a metal layer.

For example, in an image sensor, a grid pattern between color filters is introduced for the purpose of pixel isolation and have an effect of reducing crosstalk. However, when a metal layer is present in a grid pattern, there is a loss of QE due to light absorption by the metal layer. Therefore, there have been developments in that the material of a grid pattern is changed from W to a low refractive index (LRI) material and in that a barrier metal layer in a lower portion of a grid pattern includes only TiN obtained by removing Ti from a Ti/TiN combination. However, as can be seen through the graph of FIG. 6A, a barrier metal layer including TiN may also still cause the loss of QE due to light absorption.

However, the image sensor 1000 according to an embodiment may include the grid pattern 120 that is metal-free by omitting a barrier metal layer. In general, for a stain defect not to be generated in an image sensor, a charge path upon the generation of static electricity needs to be secured. When a barrier metal layer is omitted from a grid pattern, a stain defect may be generated because there is no charge path. However, in the image sensor 1000 according to an embodiment, the anti-reflective layer 110 may include the TiO₂ layer 114, and the TiO₂ layer 114 may function as a charge path. Therefore, the image sensor 1000 according to an embodiment may effectively prevent a stain defect even though the grid pattern 120 does not include a metal layer.

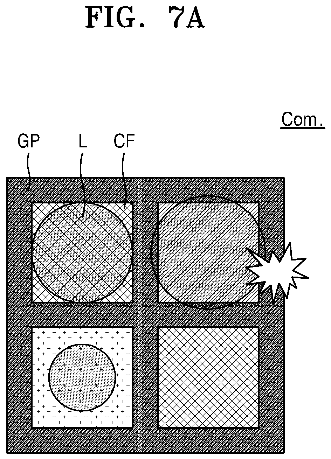

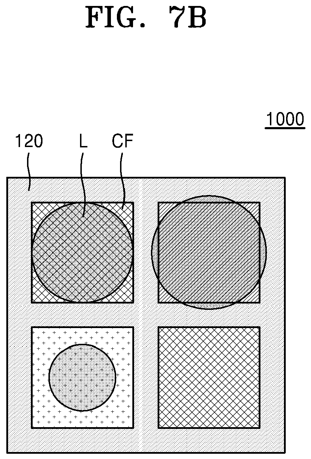

FIGS. 7A and 7B are conceptual diagrams illustrating the loss and improvement of QE in an image sensor of a related example and an image sensor according to an embodiment, respectively.

Referring to FIGS. 7A and 7B, in an image sensor Com. of a related example in FIG. 7A, a grid pattern GP may include a barrier metal layer including TiN. Therefore, in a region corresponding to a red filter (that is, CF), a portion of light L having a greater size than that of the red filter (that is, CF) may be absorbed by the barrier metal layer of the grid pattern GP, and thus, there may be a loss of QE. For reference, in FIGS. 7A and 7B, the first quadrant may correspond to the red filter (that is, CF), the second and fourth quadrants may correspond to a green filter (that is, CF), and the third quadrant may correspond to a blue filter (that is, CF). In the image sensor 1000 according to an embodiment in FIG. 7B, the grid pattern 120 may not include a metal layer. Therefore, in a region corresponding to the red filter (that is, CF), a portion of light L having a greater size than that of the red filter (that is, CF) may not be absorbed by the grid pattern 120 and may be incident on the inside of a pixel, that is, the photodiode PD, and thus, QE may be improved.

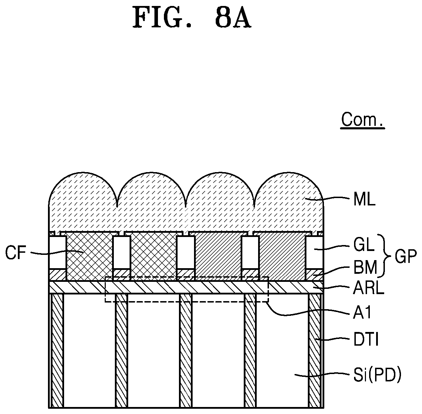

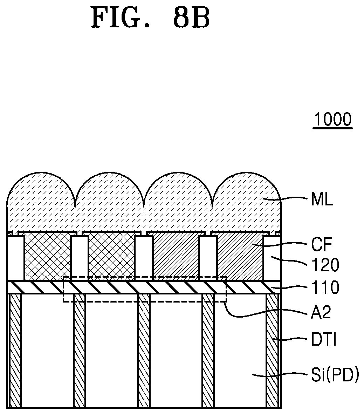

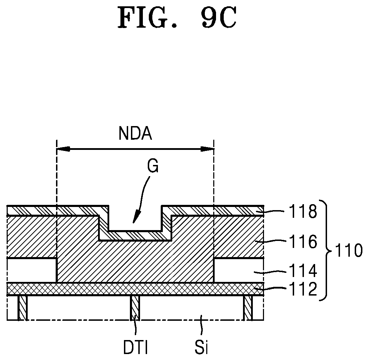

FIGS. 8A and 8B are cross-sectional views illustrating grid pattern structures of an image sensor of a related example and an image sensor according to an embodiment, respectively. FIG. 9A is an enlarged cross-sectional view of a region A1 of FIG. 8A, FIG. 9B is an enlarged cross-sectional view of a region A2 of FIG. 8B, and FIG. 9C is a cross-sectional view illustrating an anti-reflective layer of a node isolation portion of an image sensor according to an embodiment.

Referring to FIGS. 8A and 9A, in the image sensor Com. of the related example, the grid pattern GP of the pixel array region APS may include a barrier metal layer BM and a grid insulating layer GL. The barrier metal layer BM may include, for example, Ti/TiN or TiN. The grid insulating layer GL may include an insulating layer having a low refractive index. For example, the grid insulating layer GL may include TEOS or PTEOS. In the case of the image sensor Com. of the related example, because the grid pattern GP includes the barrier metal layer BM, there may be a loss of QE as described above.

In the image sensor Com. of the related example, an anti-reflective layer ARL may include four layers L1, L2, L3 and L4 stacked in the stated order on the back surface of the first substrate 101. For example, the anti-reflective layer ARL may include an AlO layer (that is, L1), a first HfOx layer (that is, L2), a PTEOS layer (that is, L3), and a second HfOx layer (that is, L4). In addition, the four layers L1 to L4 may have thicknesses of about 10 Å to about 100 Å, about 300 Å to about 700 Å, about 600 Å to about 900 Å, and about 20 Å to about 100 Å, respectively. The second HfOx layer (that is, L4) may function as an etch stop layer when the grid pattern GP on the second HfOx layer (that is, L4) is etched. That is, the second HfOx layer (that is, L4) may function as an etch stop layer with respect to the barrier metal layer BM of the grid pattern GP.

Referring to FIGS. 8B, 9B, and 9C, in the image sensor 1000 according to an embodiment, the grid pattern 120 of the pixel array region APS may include a single insulating layer. For example, the grid pattern 120 may not include a metal layer, such as a barrier metal layer. The grid pattern 120 may include an insulating layer having a low refractive index. For example, the grid pattern 120 may include TEOS, PTESO, or a porous low-k material. However, the material of the grid pattern 120 is not limited to the materials set forth above.

In the image sensor 1000 according to an embodiment, because the grid pattern 120 includes a single insulating layer, the anti-reflective layer 110 may include an AlO layer 112, a TiO₂ layer 114, a PTEOS layer 116, and a HfOx layer 118, which are stacked in the stated order on the back surface of the first substrate 101. The AlO layer 112, the TiO₂ layer 114, the PTEOS layer 116, and the HfOx layer 118 may have thicknesses of about 10 Å to about 100 Å, about 200 Å to about 400 Å, about 600 Å to about 900 Å, and about 20 Å to about 100 Å, respectively. However, the respective thicknesses of the AlO layer 112, the TiO₂ layer 114, the PTEOS layer 116, and the HfOx layer 118 are not limited to the numerical value ranges set forth above. The HfOx layer 118 may function as an etch stop layer when the grid pattern 120 on the HfOx layer 118 is etched.

In the image sensor 1000 according to an embodiment, the grid pattern 120 may not include a metal layer. In addition, the anti-reflective layer 110 may include the TiO₂ layer 114, instead of the first HfOx layer L2 in the image sensor Com. of the related example. As such, because the grid pattern 120 does not include a metal layer, the QE of the image sensor 1000 may improve. In addition, a charge path may be secured because the anti-reflective layer 110 includes the TiO₂ layer 114, thereby preventing a stain defect of the image sensor 1000. Furthermore, because the TiO₂ layer 114 is formed to a low thickness of about 200 Å to about 400 Å, the total thickness of the anti-reflective layer 110 may be reduced by about 100 Å to about 300 Å, as compared with the anti-reflective layer ARL of the image sensor Com. of the related example. In addition, as can be seen in FIG. 8A, in the image sensor Com. of the related example, due to the presence of the barrier metal layer BM, a distance between the lower surface of the grid insulating layer GL and the upper surface of the anti-reflective layer ARL may be greater than a distance between the lower surface of the color filter CF and the upper surface of the anti-reflective layer ARL. As can be seen in FIG. 8B, in the image sensor 1000 according to an embodiment, a distance between the lower surface of the grid pattern 120 and the upper surface of the anti-reflective layer 110 may be substantially equal to a distance between the lower surface of the color filter CF and the upper surface of the anti-reflective layer 110. In addition, in an embodiment, the lower surface of the grid pattern 120 and the lower surface of the color filter CF may be on substantially the same plane.

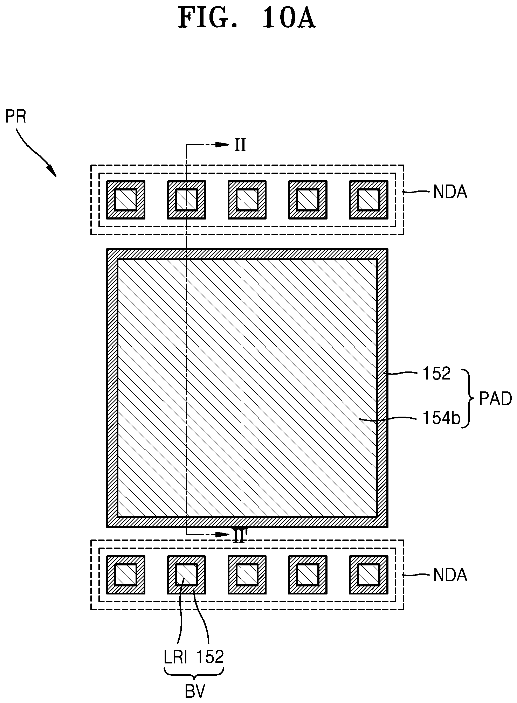

Because the anti-reflective layer 110 includes the TiO₂ layer 114 that is conductive, the TiO₂ layer 114 may be disconnected in a region requiring node isolation. FIG. 9C illustrates a structure in which the TiO₂ layer 114 is disconnected in a node isolation portion NDA. Because the TiO₂ layer 114 of the anti-reflective layer 110 is disconnected in the node isolation portion NDA, a groove G may be formed in the node isolation portion NDA. For example, as shown in FIG. 9C, in the node isolation portion NDA in which the TiO₂ layer 114 is disconnected, because the PTEOS layer 116 and the HfOx layer 118, which are arranged on or over the TiO₂ layer 114, are continuously formed with uniform thicknesses without interruption, the groove G may be formed in the node isolation portion NDA. Hereinafter, in FIGS. 10A to 12B, various node isolation portions NDA, in which the TiO₂ layer 114 is disconnected, are illustrated.

FIGS. 10A to 12B illustrate plan views of node isolation portions of the anti-reflective layer 110 of FIG. 9C in various locations of the image sensor 1000 of FIG. 1, and cross-sectional views corresponding to the plan views.

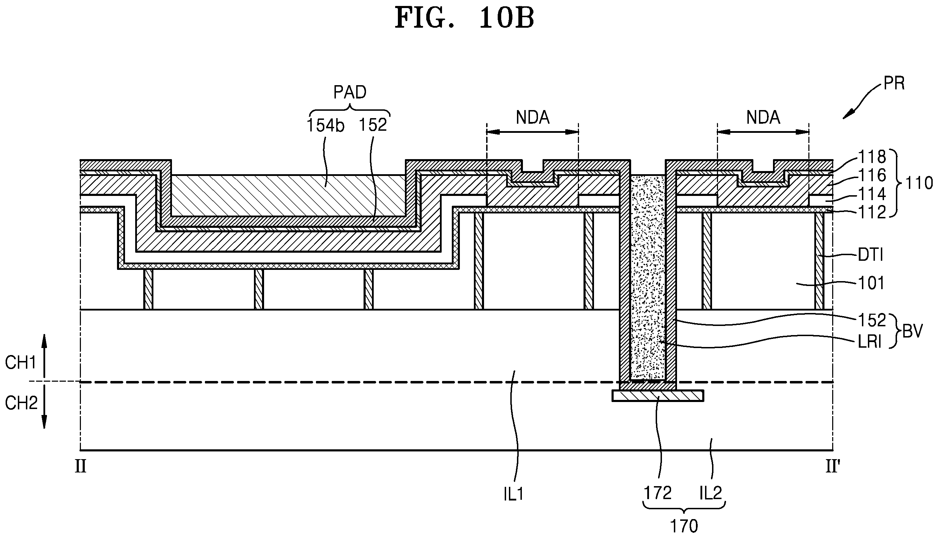

Referring to FIGS. 10A and 10B, the node isolation portion NDA in the pad region PR of the peripheral area PE is illustrated. The node isolation portion NDA may be arranged in a structure surrounding the backside vias BV. For example, as shown in FIGS. 4 and 10A, the backside vias BV may be arranged linearly on both sides of the pad PAD. In addition, the node isolation portion NDA may have a structure surrounding each of the backside vias BV arranged linearly, as indicated by double dashed lines of rectangular shapes. For example, in FIGS. 10A to 12B, the first insulating layer 156, the second insulating layer 158, and the like, which are arranged on or over the first conductive layer 152, are omitted and not shown.

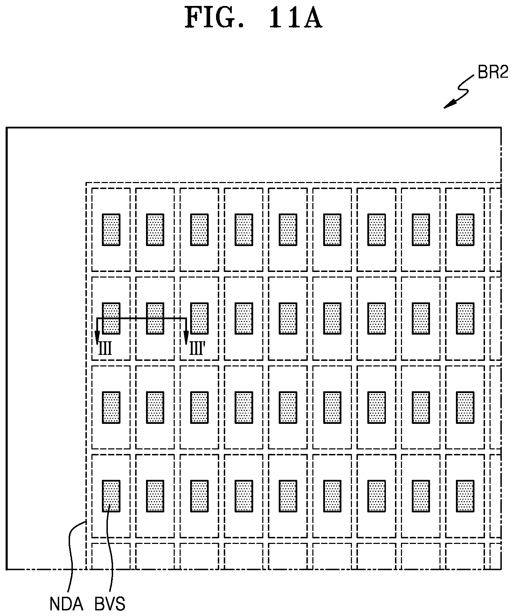

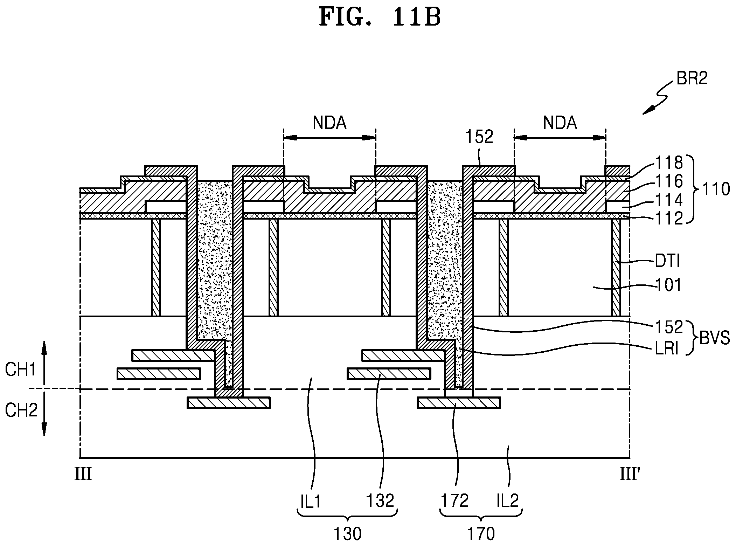

Referring to FIGS. 11A and 11B, the node isolation portion NDA in the backside via stack region BR2 is illustrated. The node isolation portion NDA may be adjacent to and surround the backside via stack BVS. For example, as shown in FIG. 11A, the backside via stacks BVS may be arranged in a 2-dimensional array structure in the backside via stack region BR2. In addition, the node isolation portion NDA may surround the backside via stacks BVS while having a grid shape, as indicated by double dashed lines.

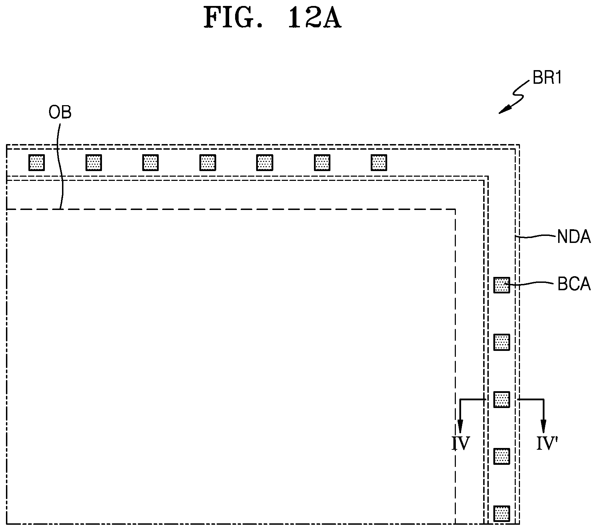

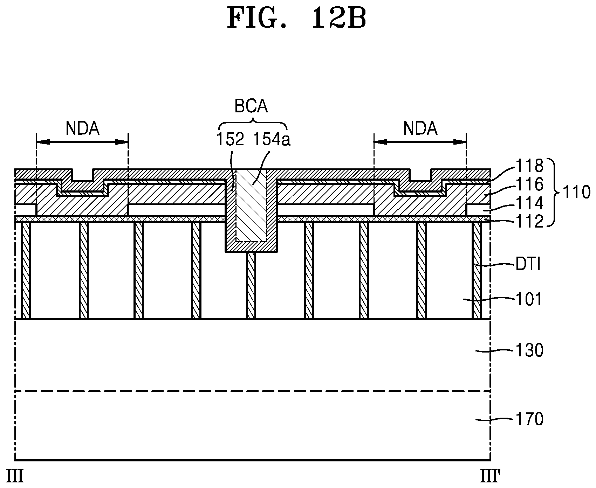

Referring to FIGS. 12A and 12B, the node isolation portion NDA in the contact region BR1 outside the pixel area PA is illustrated. The node isolation portion NDA may be arranged on both sides of the backside contact BCA. For example, as shown in FIG. 12A, the backside contacts BCA may be arranged with certain intervals around the light-blocking region OB, along a line surrounding the light-blocking region OB. In addition, the node isolation portion NDA may extend linearly on both sides of the backside contacts BCA to surround each of the backside contacts BCA, as indicated by double dashed lines.

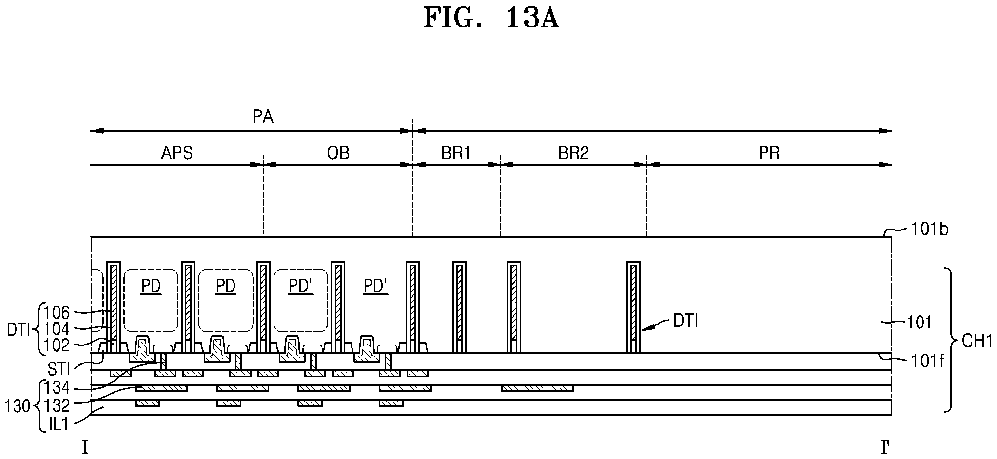

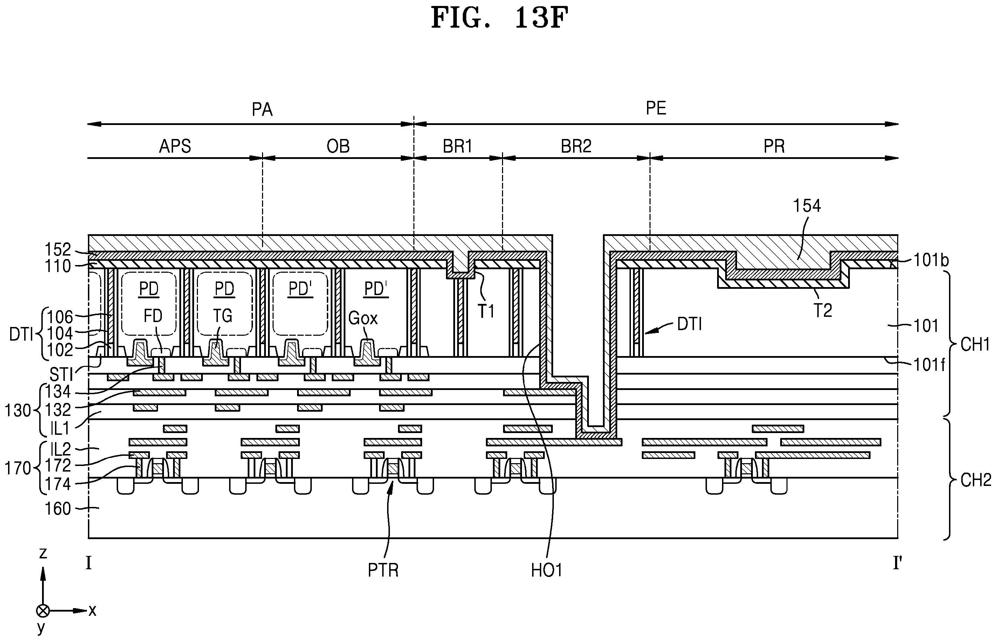

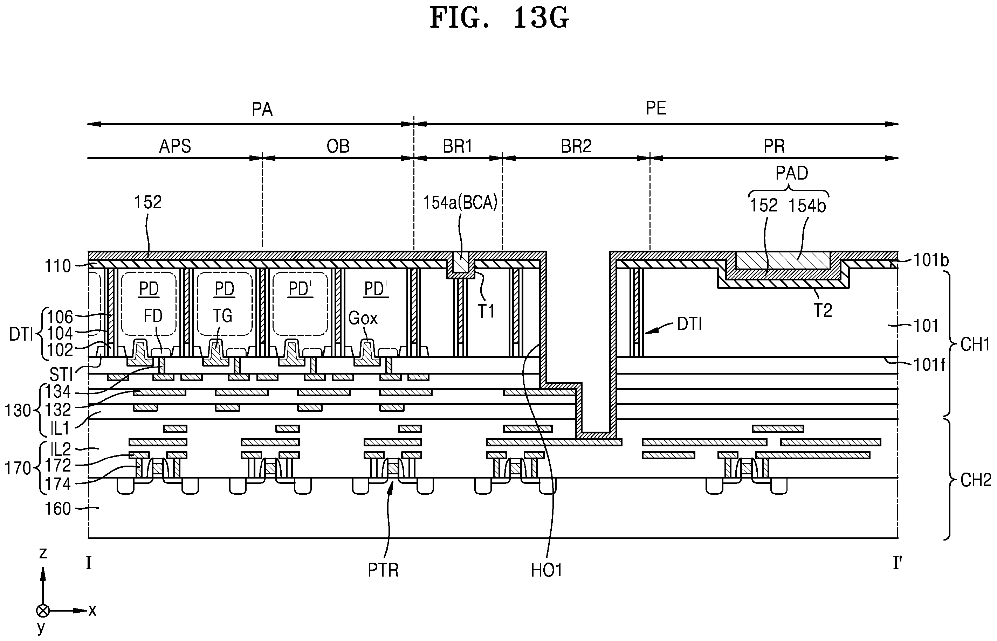

FIGS. 13A to 13K are cross-sectional views respectively illustrating a sequence of processes of a method of manufacturing an image sensor, according to an embodiment. Descriptions are made with reference to FIGS. 13A to 13K together with FIGS. 4 and 5, and the descriptions already given with reference to FIGS. 1 to 12B are made briefly or omitted.

Referring to FIG. 13A, according to the method of manufacturing an image sensor, according to an embodiment, the first semiconductor chip CH1 is fabricated. For example, the device isolation unit STI, the pixel isolation unit DTI, and the photodiode PD are formed in the first substrate 101 including the pixel area PA and the peripheral area PE. The device isolation unit STI may define an active region, and the pixel isolation unit DTI may define a region of the unit pixel UP. The photodiode PD may be formed by performing an ion implantation process and the like. Next, pixel transistors constituting the unit pixel UP are formed in the active region. Then, the first wiring layer 130 is formed on the front surface 101f of the first substrate 101. The first wiring layer 130 may include the first interlayer dielectric IL1, the first wiring lines 132, and the first via contact 134.

In parallel with the fabrication of the first semiconductor chip CH1, the second semiconductor chip CH2 is fabricated. The second semiconductor chip CH2 may include the second substrate 160 and the second wiring layer 170. The transistors PTR for logic devices may be arranged in the second substrate 160. The second wiring layer 170 may be arranged on an active surface, that is, a front surface, of the second substrate 160 and may include the second interlayer dielectric IL2, the second wiring lines 172, and the second via contact 174.

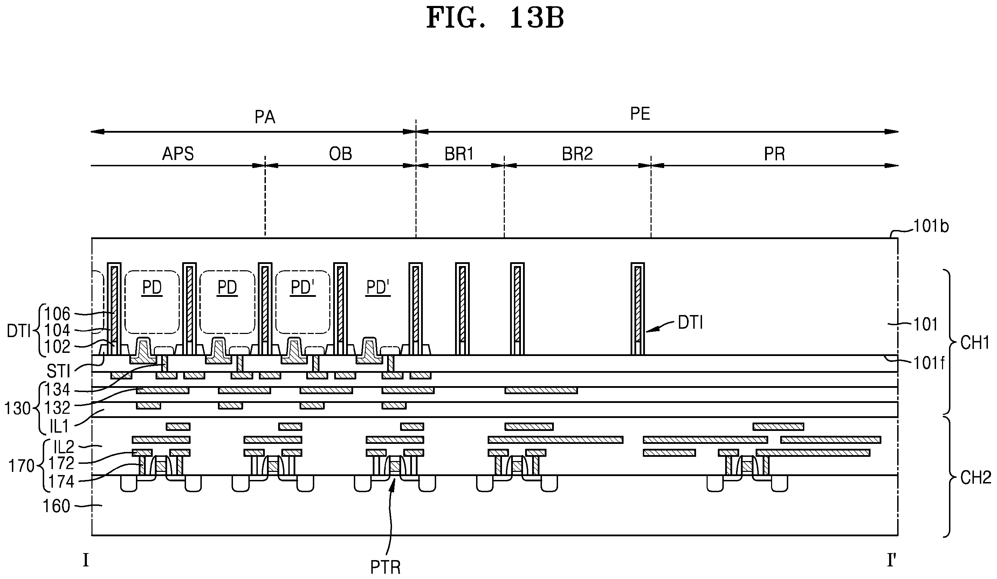

Referring to FIG. 13B, after the first semiconductor chip CH1 and the second semiconductor chip CH2 are fabricated, the first interlayer dielectric IL1 is aligned with the second interlayer dielectric IL2, followed by performing a thermal compression process or the like, thereby bonding and coupling the first semiconductor chip CH1 onto the second semiconductor chip CH2.

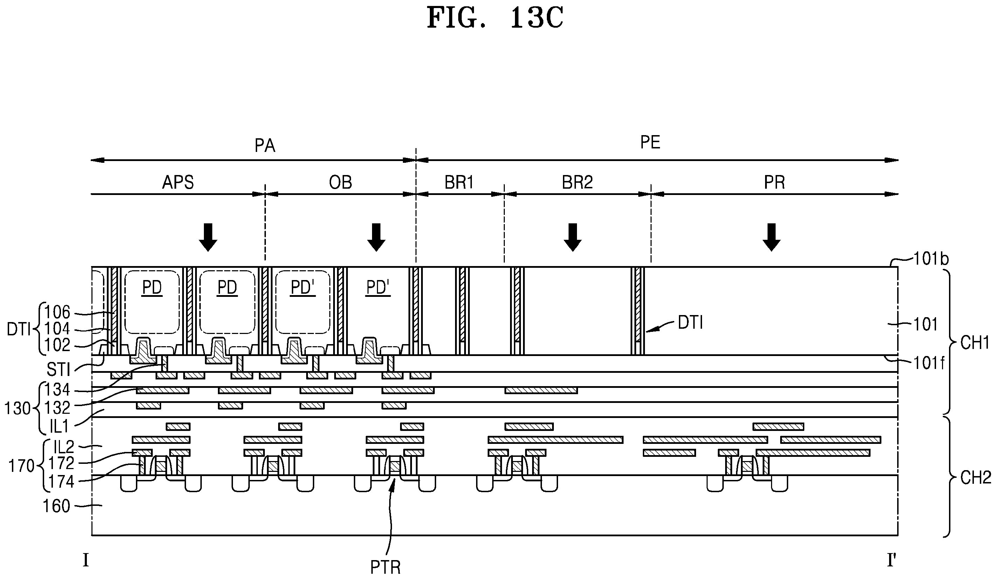

Referring to FIG. 13C, as indicated by bold arrows, a grinding process is performed on the back surface 101b of the first substrate 101, thereby reducing the thickness of the first substrate 101. The conductive pattern 106 of the pixel isolation unit DTI may be exposed by the grinding process. In some embodiments, the side insulating layer 104 of the pixel isolation unit DTI may be exposed by the grinding process. The process of thinning the first substrate 101 may further include a chemical mechanical polishing (CMP) process. In such a CMP process, the conductive pattern 106 of the pixel isolation unit DTI may be used as an etch stop layer, or the side insulating layer 104 of the pixel isolation unit DTI may be used as an etch stop layer.

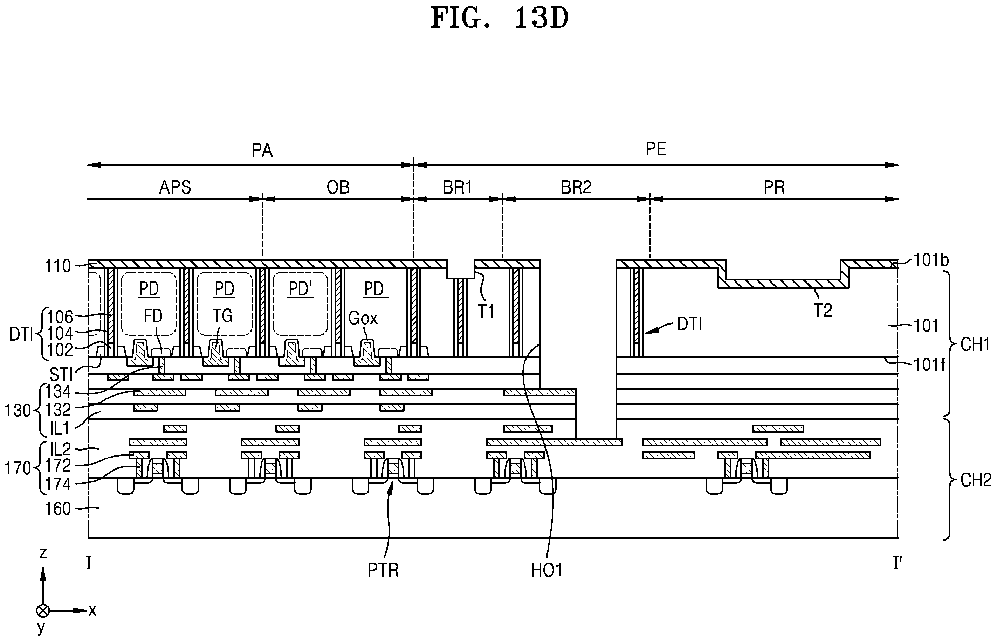

Referring to FIG. 13D, in the pad region PR of the peripheral area PE, to form a pad on the back surface 101b of the first substrate 101, the second trench T2 is formed in the substrate 101 in the pad region PR by etching a portion of the first substrate 101. Next, the anti-reflective layer 110 including multiple layers is formed. For example, the anti-reflective layer 110 may include the AlO layer 112, the TiO₂ layer 114, the PTEOS layer 116, and the HfOx layer 118, which are stacked in the stated order on the back surface 101b of the first substrate 101. Each of the multiple layers of the anti-reflective layer 110 may be formed by atomic layer deposition (ALD), chemical vapor deposition (CVD), physical vapor deposition (PVD), or the like. When the anti-reflective layer 110 is formed, as described with reference to FIGS. 9C to 12B, the node isolation portion NDA, in which the TiO₂ layer 114 is disconnected, may be formed.

Next, in the contact region BR1, the first trench T1 is formed by etching certain portions of the anti-reflective layer 110 and the first substrate 101. When the first trench T1 is formed, the pixel isolation unit DTI may be partially etched, and thus, the conductive pattern 106 of the pixel isolation unit DTI may be exposed. In addition, in the backside via stack region BR2, the anti-reflective layer 110, the first substrate 101, the first interlayer dielectric IL1, and the second interlayer dielectric IL2 are partially etched, thereby forming the first hole HO1 for forming the backside via stack BVS. As can be seen in FIG. 4, when the first hole HO1 is formed, a second hole for forming the backside via BV may also be formed around the second trench T2 of the pad region PR.

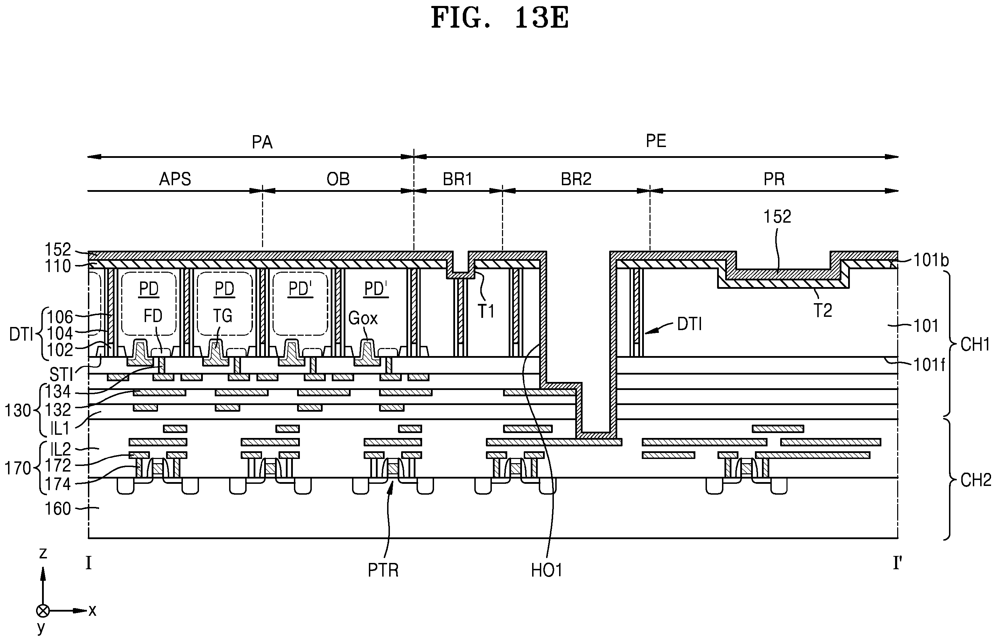

Referring to FIGS. 13E to 13G, in the pixel area PA and the peripheral area PE, the first conductive layer 152 and the second conductive layer 154 are formed in the stated order on the back surface 101b of the first substrate 101. For example, the first conductive layer 152 may include W and the second conductive layer 154 may include Al. However, the materials of the first conductive layer 152 and the second conductive layer 154 are not limited to the materials set forth above. Next, the second conductive layer 154 is left only inside the trenches (that is, T1 and T2) of the pad region PR and the contact region BR1 through an etching process, thereby forming the first and second metal patterns 154a and 154b. In some embodiments, a barrier metal layer including Ti may be further formed under the first conductive layer 152. In addition, a barrier metal layer including TiN may be further formed on and under the second conductive layer 154. The first conductive layer 152 and the first metal pattern 154a may constitute the backside contact BCA, and the first conductive layer 152 and the second metal pattern 154b may constitute the pad PAD.

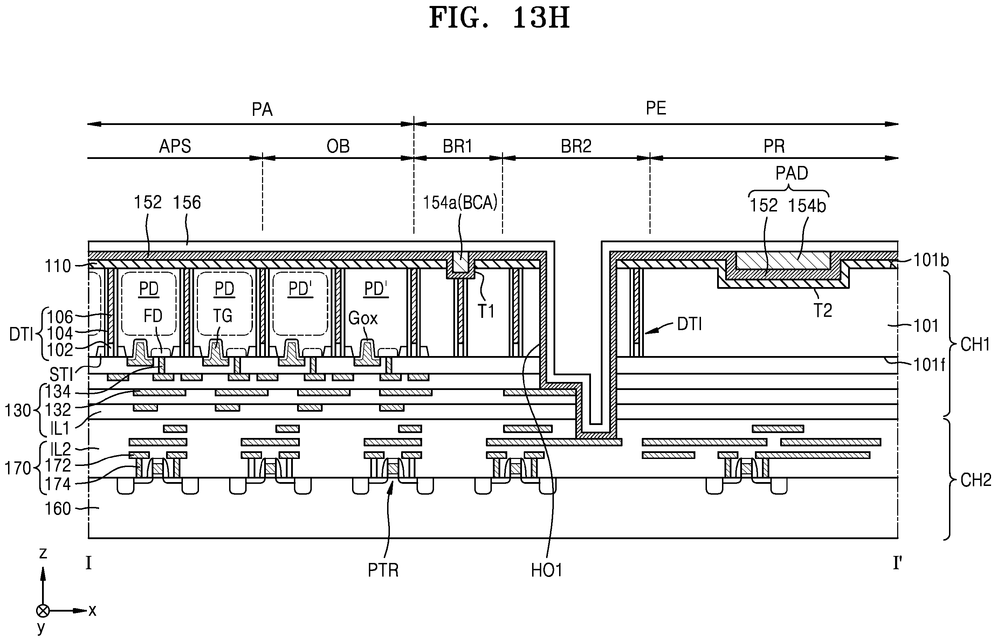

Referring to FIG. 13H, the first insulating layer 156 is formed in the pixel area PA and the peripheral area PE. Here, the first insulating layer 156 may also be formed in the first holes HO1 of the backside via stack region BR2. In addition, although not shown, the first insulating layer 156 may also be formed in the second holes for the backside via BV. For example, the first insulating layer 156 may include, for example, silicon oxide.

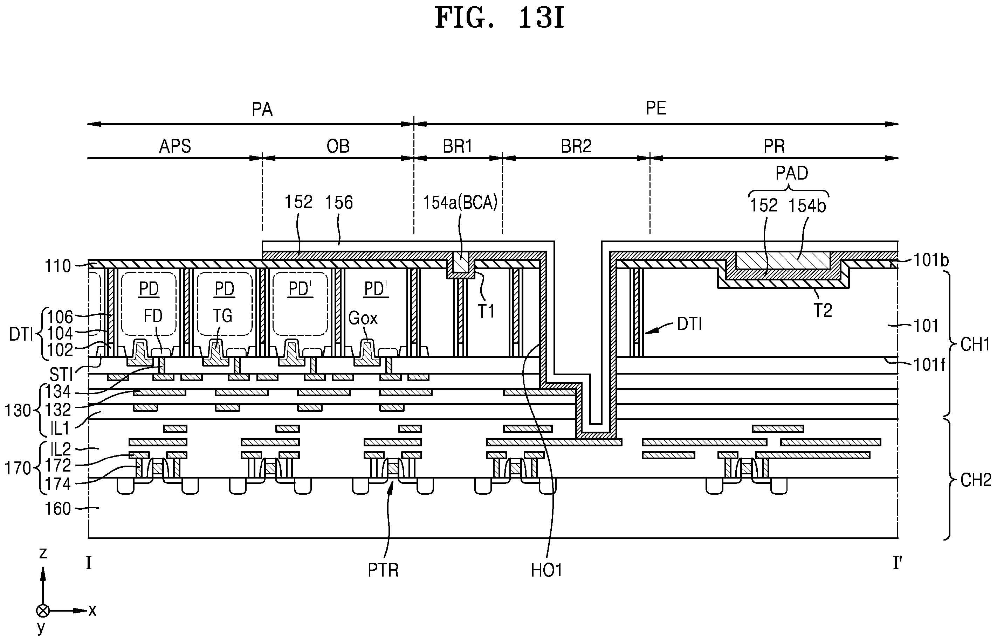

Referring to FIG. 13I, the first conductive layer 152 and the first insulating layer 156, which are formed in the pixel array region APS, are removed.

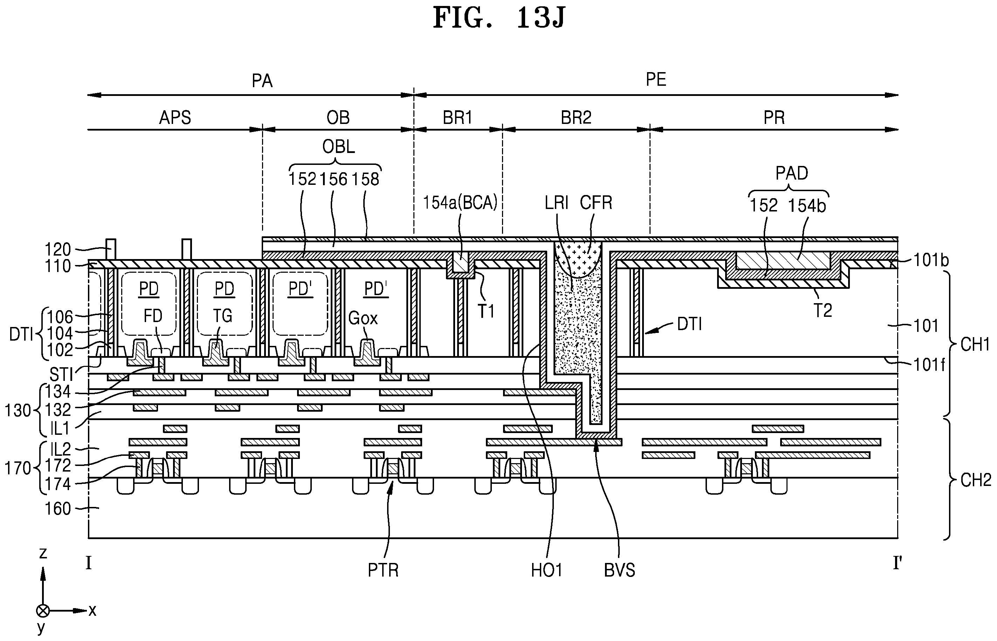

Referring to FIG. 13J, the grid pattern 120 is formed in the pixel array region APS. The grid pattern 120 may include a single insulating layer having a low refractive index. A low-refractive-index material layer may be formed on a structure on the back surface 101b of the first substrate 101, followed by patterning the low-refractive-index material layer in the pixel array region APS through a patterning process, thereby forming the grid pattern 120. When the grid pattern 120 is formed, the low-refractive-index material layer may fill the inside of the first hole HO1 and thus constitute the protective pattern LRI. Next, the second insulating layer 158 may be formed in the light-blocking region OB and the peripheral area PE. The first conductive layer 152, the first insulating layer 156, and the second insulating layer 158 may constitute the light-blocking layer OBL. In addition, the capping pattern CFR may be formed in an upper portion of the first hole HO1 by using a negative photoresist before forming the second insulating layer 158, thereby forming the backside via stack BVS. Next, to electrically block the pad PAD of the pad region PR and the backside via stack BVS of the backside via stack region BR2 from each other, a blocking groove BG is formed by removing the first conductive layer 152, the first insulating layer 156 and the second insulating layer 158. In addition, to electrically block the backside contact BCA of the contact region BR1 and the backside via stack BVS of the backside via stack region BR2 from each other, a blocking groove BG may be formed by removing the first conductive layer 152, the first insulating layer 156 and the second insulating layer 158.

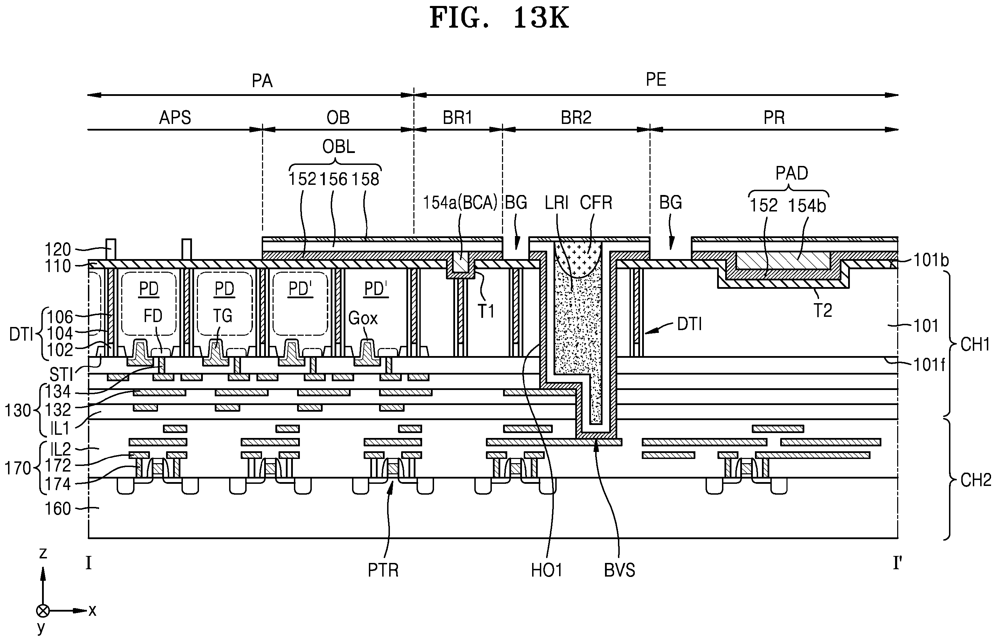

Referring to FIG. 13K, in succession, the color filters CF1 and CF2 are formed in the pixel array region APS. Color filters may not be formed in the light-blocking region OB and the peripheral area PE. The color filters CF1 and CF2 may each fill the inside of a grid of the grid pattern 120 and may be separated from each other by the grid pattern 120. In the image sensor 1000 according to an embodiment, the color filters CF1 and CF2 may each have, for example, one color from among blue, green, and red colors. In addition, the color filters CF1 and CF2 may be arranged in a Bayer pattern form. However, color combinations and pattern shapes of the color filters CF1 and CF2 are not limited to the example set forth above.

Next, a material layer for micro-lenses is coated to cover a structure on the back surface 101b of the first substrate 101, followed by forming the micro-lens ML in the pixel array region APS and forming the lens remaining layer MLR in the other regions. In addition, in the pad region PR, the lens remaining layer MLR, the second insulating layer 158, the first insulating layer 156, and the like may be removed, and thus, the opening OP may be formed to expose the pad PAD, thereby manufacturing the image sensor 1000 of FIG. 5.

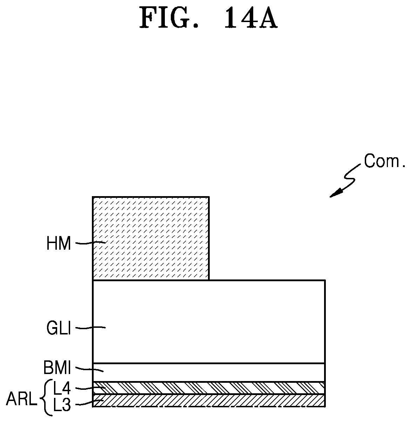

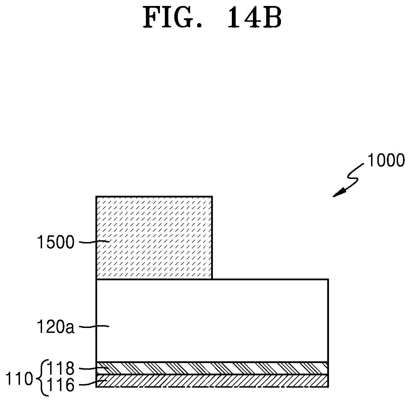

FIGS. 14A and 14B are cross-sectional views illustrating processes of forming a grid pattern in an image sensor of a related example and an image sensor of an embodiment, respectively. Descriptions are made with reference to FIGS. 14A and 14B together with FIG. 8A and 8B.

Referring to FIG. 14A, in the case of the image sensor Com. of the related example, as shown in FIG. 8A, the grid pattern GP may include the barrier metal layer BM in a lower portion thereof. Therefore, to form the grid pattern GP, a lower metal layer BM1 and an upper insulating layer GL1 are formed on the anti-reflective layer ARL. The lower metal layer BM1 may include, for example, a TiN layer, and the upper insulating layer GL1 may include a low-refractive-index material, for example, TEOS or PTEOS.

Next, a hard mask HM is formed on the upper insulating layer GL1 through a photolithography process. According to some embodiments, a photoresist (PR) pattern may be maintained on the hard mask HM. In succession, the lower metal layer BM1 and the upper insulating layer GL1 are etched by using the hard mask HM as an etch mask, thereby forming the grid insulating layer GL and the barrier metal layer BM. In the etching process, the second HfOx layer L4 of the anti-reflective layer ARL may function as an etch stop layer.

Referring to FIG. 14B, in the case of the image sensor 1000 according to an embodiment, as shown in FIG. 8B, the grid pattern 120 may include a single insulating layer without a separate barrier metal layer in a lower portion thereof. Therefore, to form the grid pattern 120, a low-refractive-index material layer 120a is formed on the anti-reflective layer 110. The low-refractive-index material layer 120a may include, for example, TEOS, PTEOS, a porous low-k material, or the like. However, the material of the low-refractive-index material layer 120a is not limited to the materials set forth above.

Next, a hard mask 1500 is formed on the low-refractive-index material layer 120a through a photolithography process. According to some embodiments, a PR pattern may be maintained on the hard mask 1500. In succession, the low-refractive-index material layer 120a is etched by using the hard mask 1500 as an etch mask, thereby forming the grid pattern 120. In the etching process, the HfOx layer 118 of the anti-reflective layer 110 may function as an etch stop layer.

## Claims

1. An image sensor comprising:
a first substrate (101) comprising a pixel area (PA; 100) and a peripheral area (PE) adjacent to the pixel area (PA; 100), the pixel area (PA; 100) comprising a plurality of pixels in a 2-dimensional array;
a first wiring layer (130) on a lower surface of the first substrate (101);
an anti-reflective layer (110) having a first refractive index, the anti-reflective layer (110) being on an upper surface of the first substrate (101), the anti-reflective layer (110) comprising a TiO₂ layer (114); and
color filters (CF1, CF2) on the anti-reflective layer (110) corresponding to the pixel area (PA; 100) and spaced apart from each other, and
characterized that
the color filters are spaced apart from each other by a metal-free grid pattern (120), and
the TiO₂ layer (114) is disconnected in a node isolation portion (NDA).

2. The image sensor of claim 1, wherein the color filters (CF1, CF2) are in a 2-dimensional array corresponding to the plurality of pixels,
wherein the metal-free grid pattern (120) has a 2-dimensional grid shape and is between the color filters (CF1, CF2), and
wherein the metal-free grid pattern (120) comprises a single insulating layer having a second refractive index that is lower than the first refractive index.

3. The image sensor of claim 1, further comprising
backside contacts (BCA) linearly disposed at certain intervals along a line on an peripheral portion of the pixel area (PA; 100),
wherein the node isolation portion (NDA) extends on both sides of the backside (BCA) contacts along the line.

4. The image sensor of claim 3, further comprising through-vias (BVS) in a 2-dimensional array on a portion (BR2) of the peripheral area (PE),
wherein the node isolation portion (NDA) is adjacent to each of the through-vias (BVS) in a 2-dimensional grid shape.

5. The image sensor of claim 1, further comprising through-vias (BV) adjacent to and on at least one side of each of metal pads (PAD) in a peripheral portion (PR) of the peripheral area (PE), and
wherein the node isolation portion (NDA) is adjacent to each of the through-vias (BVS).

6. The image sensor of claim 1, wherein the anti-reflective layer (110) further comprises an AlO layer (112), which is under the TiO₂ layer (114), and a tetraethly orthosilicate, TEOS, layer (116) and a HfOx layer (118), which are over the TiO₂ layer (114).

7. The image sensor of claim 6,
wherein the AlO layer (112), the TEOS layer (116), and the HfOx layer (118) each continuously extend in the node isolation portion (NDA).

8. The image sensor of claim 1, wherein a distance between a lower surface of the metal-free grid pattern (120) and an upper surface of the anti-reflective layer (110) is equal to a distance between a lower surface of each of the color filters (CF1, CF2) and the upper surface of the anti-reflective layer (110).

9. A method of manufacturing an image sensor, the method comprising:
forming a plurality of pixels, respectively comprising a photodiode (PD), in a pixel area (PA; 100) of a first substrate (101) of a first semiconductor chip (CH1) and forming a first wiring layer (130) on an active surface (101f) of the first substrate (101);
forming a logic device in a second substrate (160) of a second semiconductor chip (CH2) and forming a second wiring layer (170) on an active surface of the second substrate (160);
connecting the first semiconductor chip (CH1) and the second semiconductor chip (CH2) to each other such that the first wiring layer (130) faces the second wiring layer (170);
removing a portion of an inactive surface side of the first substrate (101);
forming an anti-reflective layer (110) with a first refractive index on the inactive surface (101b) of the first substrate (101);
forming through-vias (BVS) in a peripheral area (PE) of the first substrate (101), the peripheral area (PE) being adjacent to the pixel area (PA; 100) of the first substrate (101);
forming color filters (CF1, CF2), respectively corresponding to the plurality of pixels, on the anti-reflective layer (110) of the pixel area (PA; 100); and
forming micro-lenses (ML) respectively on the color filters (CF1, CF2),
wherein the forming of the color filters (CF1, CF2) comprises:
forming a metal-free grid pattern (120), having a 2-dimensional grid shape, in the pixel area (PA; 100); and
forming the color filters (CF1, CF2) respectively in grids of the metal-free grid pattern (120),
wherein the metal-free grid pattern (120) comprises a single insulating layer having a second refractive index that is lower than the first refractive index, and
**characterized in that**
the anti-reflective layer (110) comprises a TiO₂ layer (114) that is disconnected in a node isolation portion (NDA).

10. The method of claim 9, wherein the anti-reflective layer (110) further comprises an AlO layer (112), which is under the TiO₂ layer (114), and a tetraethly orthosilicate (TEOS) layer and a HfOx layer (L4; 118), which are over the TiO₂ layer (114), and
wherein the HfOx layer (L4; 118) functions as an etch stop layer when the single insulating layer is patterned.

11. The method of claim 10, wherein, in the forming of the anti-reflective layer (110), the node isolation portion (NDA), in which the TiO₂ layer (114) is disconnected, is formed adjacent to:
each of backside contacts (BCA) linearly disposed at certain intervals adjacent to a peripheral portion of the pixel area (PA; 100);
each of first through-vias (BVS) in a 2-dimensional array structure in a portion of the peripheral area (PE); and
each of second through-vias (BVS) adjacent to and on at least one side of each of metal pads (PAD) in a peripheral portion of the peripheral area (PE).

12. The method of claim 11, wherein, in the node isolation portion (NDA), the AlO layer (112), the TEOS layer, and the HfOx layer (L4; 118) each continuously extend.

## Patentansprüche

1. Bildsensor, aufweisend:
ein erstes Substrat (101) aufweisend einen Pixelbereich (PA; 100) und einen an den Pixelbereich (PA; 100) angrenzenden Peripheriebereich (PE), wobei der Pixelbereich (PA; 100) eine Vielzahl von Pixeln in einem zweidimensionalen Array aufweist;
eine erste Verdrahtungsschicht (130) auf einer Unterseite des ersten Substrats (101);
eine Antireflexschicht (110) mit einem ersten Brechungsindex, wobei die Antireflexschicht (110) auf einer Oberseite des ersten Substrats (101) angeordnet ist und eine TiO₂-Schicht (114) aufweist; und
Farbfilter (CF1, CF2) auf der Antireflexschicht (110), die dem Pixelbereich (PA; 100) zugeordnet und voneinander beabstandet sind,
**dadurch gekennzeichnet, dass**
die Farbfilter durch ein metallfreies Gittermuster (120) voneinander beabstandet sind,
und
die TiO₂-Schicht (114) in einem Knoten-Isolationsbereich (NDA) unterbrochen ist.

2. Bildsensor nach Anspruch 1, wobei die Farbfilter (CF1, CF2) in einem zweidimensionalen Array entsprechend der Vielzahl von Pixeln angeordnet sind,
wobei das metallfreie Gittermuster (120) eine zweidimensionale Gitterform aufweist und zwischen den Farbfiltern (CF1, CF2) angeordnet ist, und
wobei das metallfreie Gittermuster (120) eine einzelne Isolierschicht aufweist, die einen zweiten Brechungsindex aufweist, der niedriger ist als der erste Brechungsindex.

3. Bildsensor nach Anspruch 1, ferner aufweisend
Rückseitenkontakte (BCA), die in vorgegebenen Abständen linear entlang einer Linie in einem Randabschnitt des Pixelbereichs (PA; 100) angeordnet sind,
wobei sich der Knoten-Isolationsbereich (NDA) entlang der Linie beidseitig der Rückseitenkontakte (BCA) erstreckt.

4. Bildsensor nach Anspruch 3, ferner aufweisend Durchkontaktierungen (BVS) in einem zweidimensionalen Array auf einem Abschnitt (BR2) des Peripheriebereichs (PE),
wobei der Knoten-Isolationsbereich (NDA) in Form eines zweidimensionalen Gitters jeweils an jede der Durchkontaktierungen (BVS) angrenzt.

5. Bildsensor nach Anspruch 1, ferner aufweisend Durchkontaktierungen (BVS), die in einem peripheren Abschnitt (PR) des Peripheriebereichs (PE) an Metallpads (PAD) angrenzen und auf mindestens einer Seite jedes der Metallpads (PAD) angeordnet sind, und
wobei der Knoten-Isolationsbereich (NDA) an jede der Durchkontaktierungen (BVS) angrenzt.

6. Bildsensor nach Anspruch 1, wobei die Antireflexschicht (110) ferner eine AlO-Schicht (112) aufweist, die unter der TiO₂-Schicht (114) angeordnet ist, sowie eine Tetraethylorthosilikat, TEOS,-Schicht (116) und eine HfOx-Schicht (118), die über der TiO₂-Schicht (114) angeordnet sind.

7. Bildsensor nach Anspruch 6,
wobei sich die AlO-Schicht (112), die TEOS-Schicht (116) und die HfOx-Schicht (118) jeweils im Knoten-Isolationsbereich (NDA) kontinuierlich erstrecken.

8. Bildsensor nach Anspruch 1, wobei ein Abstand zwischen einer Unterseite des metallfreien Gittermusters (120) und einer Oberseite der Antireflexschicht (110) gleich einem Abstand zwischen einer Unterseite jedes der Farbfilter (CF1, CF2) und der Oberseite der Antireflexschicht (110) ist.

9. Verfahren zur Herstellung eines Bildsensors, wobei das Verfahren aufweist:
Bilden einer Vielzahl von Pixeln, die jeweils eine Photodiode (PD) aufweisen, in einem Pixelbereich (PA; 100) eines ersten Substrats (101) eines ersten Halbleiterchips (CH1) und Bilden einer ersten Verdrahtungsschicht (130) auf einer aktiven Oberfläche (101f) des ersten Substrats (101);
Bilden eines Logikbauelements in einem zweiten Substrat (160) eines zweiten Halbleiterchips (CH2) und Bilden einer zweiten Verdrahtungsschicht (170) auf einer aktiven Oberfläche des zweiten Substrats (160);
Verbinden des ersten Halbleiterchips (CH1) und des zweiten Halbleiterchips (CH2) miteinander derart, dass die erste Verdrahtungsschicht (130) der zweiten Verdrahtungsschicht (170) gegenüberliegt;
Entfernen eines Teils von der inaktiven Oberflächenseite des ersten Substrats (101);
Bilden einer Antireflexschicht (110) mit einem ersten Brechungsindex auf der inaktiven Oberfläche (101b) des ersten Substrats (101);
Bilden von Durchkontaktierungen (BVS) in einem Peripheriebereich (PE) des ersten Substrats (101), wobei der Peripheriebereich (PE) an den Pixelbereich (PA; 100) des ersten Substrats (101) angrenzt;
Bilden von Farbfiltern (CF1, CF2), die jeweilig der Vielzahl von Pixeln zugeordnet sind, auf der Antireflexschicht (110) des Pixelbereichs (PA; 100); und
Bilden von Mikrolinsen (ML) jeweilig auf den Farbfiltern (CF1, CF2),
wobei das Bilden der Farbfilter (CF1, CF2) aufweist:
Bilden eines metallfreien Gittermusters (120) mit einer zweidimensionalen Gitterform im Pixelbereich (PA; 100); und
Bilden der Farbfilter (CF1, CF2) jeweils in Maschen des metallfreien Gittermusters (120),
wobei das metallfreie Gittermuster (120) eine einzelne Isolierschicht aufweist, die einen zweiten Brechungsindex aufweist, der niedriger ist als der erste Brechungsindex, und
**dadurch gekennzeichnet, dass**
die Antireflexschicht (110) eine TiO₂-Schicht (114) aufweist, die in einem Knoten-Isolationsbereich (NDA) unterbrochen ist.

10. Verfahren nach Anspruch 9, wobei die Antireflexschicht (110) ferner eine AlO-Schicht (112) aufweist, die unter der TiO₂-Schicht (114) angeordnet ist, sowie eine Tetraethylorthosilikat, TEOS,-Schicht und eine HfOx-Schicht (L4; 118), die über der TiO₂-Schicht (114) angeordnet sind, und
wobei die HfOx-Schicht (L4; 118) als Ätzstopp-Schicht fungiert, wenn die einzelne Isolierschicht strukturiert wird.

11. Verfahren nach Anspruch 10, wobei beim Bilden der Antireflexschicht (110) der Knoten-Isolationsbereich (NDA), in dem die TiO₂-Schicht (114) unterbrochen ist, angrenzend an Folgendes gebildet wird:
jeweils Rückseitenkontakte (BCA), die linear in vorgegebenen Abständen angrenzend an einen Randabschnitt des Pixelbereichs (PA; 100) angeordnet sind;
jeweils erste Durchkontaktierungen (BVS) in einer zweidimensionalen Array-Struktur in einem Abschnitt des Peripheriebereichs (PE); und
jeweils zweite Durchkontaktierungen (BVS), die in einem peripheren Abschnitt des Peripheriebereichs (PE) an Metallpads (PAD) angrenzen und auf mindestens einer Seite jedes der Metallpads (PAD) angeordnet sind.

12. Verfahren nach Anspruch 11, wobei sich im Knoten-Isolationsbereich (NDA) die AlO-Schicht (112), die TEOS-Schicht und die HfOx-Schicht (L4; 118) jeweils kontinuierlich erstrecken.

## Revendications

1. Capteur d'image comprenant :
un premier substrat (101) comprenant une zone de pixels (PA ; 100) et une zone périphérique (PE) adjacente à la zone de pixels (PA ; 100), la zone de pixels (PA ; 100) comprenant une pluralité de pixels disposés selon un réseau bidimensionnel ;
une première couche d'interconnexion (130) sur une surface inférieure du premier substrat (101) ;
une couche antireflet (110) présentant un premier indice de réfraction, la couche antireflet (110) étant disposée sur une surface supérieure du premier substrat (101), la couche antireflet (110) comprenant une couche de TiO₂ (114) ; et
des filtres de couleur (CF1, CF2) disposés sur la couche antireflet (110), correspondant à la zone de pixels (PA ; 100) et espacés les uns des autres,
**caractérisé en ce que**
les filtres de couleur sont espacés les uns des autres par un motif de grille sans métal (120), et
la couche de TiO₂ (114) est interrompue dans une zone d'isolement de nœud (NDA).

2. Capteur d'image selon la revendication 1, dans lequel les filtres de couleur (CF1, CF2) sont disposés selon un réseau bidimensionnel correspondant à la pluralité de pixels,
dans lequel le motif de grille sans métal (120) a une forme de grille bidimensionnelle et est disposé entre les filtres de couleur (CF1, CF2), et
dans lequel le motif de grille sans métal (120) comprend une seule couche isolante présentant un deuxième indice de réfraction inférieur au premier indice de réfraction.

3. Capteur d'image selon la revendication 1, comprenant en outre
des contacts arrière (BCA) disposés linéairement, à des intervalles prédéterminés, le long d'une ligne sur une portion périphérique de la zone de pixels (PA ; 100),
dans lequel la zone d'isolement de nœud (NDA) s'étend, le long de ladite ligne, de part et d'autre des contacts arrière (BCA).

4. Capteur d'image selon la revendication 3, comprenant en outre des vias traversants (BVS) disposés selon un réseau bidimensionnel sur une portion (BR2) de la zone périphérique (PE),
dans lequel la zone d'isolement de nœud (NDA) est adjacente à chacun des vias traversants (BVS) selon une forme de grille bidimensionnelle.

5. Capteur d'image selon la revendication 1, comprenant en outre des vias traversants (BV) adjacents à, et sur au moins un côté de, chacun des plots métalliques (PAD) dans une portion périphérique (PR) de la zone périphérique (PE), et
dans lequel la zone d'isolement de nœud (NDA) est adjacente à chacun des vias traversants (BVS).

6. Capteur d'image selon la revendication 1, dans lequel la couche antireflet (110) comprend en outre une couche d'AlO (112) située sous la couche de TiO₂ (114), ainsi qu'une couche de tétraéthylorthosilicate, TEOS, (116) et une couche de HfOx (118) situées au-dessus de la couche de TiO₂ (114).

7. Capteur d'image selon la revendication 6,
dans lequel la couche d'AlO (112), la couche de TEOS (116) et la couche de HfOx (118) s'étendent chacune de manière continue dans la zone d'isolement de nœud (NDA).

8. Capteur d'image selon la revendication 1, dans lequel une distance entre une surface inférieure du motif de grille sans métal (120) et une surface supérieure de la couche antireflet (110) est égale à une distance entre une surface inférieure de chacun des filtres de couleur (CF1, CF2) et la surface supérieure de la couche antireflet (110).

9. Procédé de fabrication d'un capteur d'image, le procédé comprenant :
former une pluralité de pixels, comprenant respectivement une photodiode (PD), dans une zone de pixels (PA ; 100) d'un premier substrat (101) d'une première puce semi-conductrice (CH1), et former une première couche d'interconnexion (130) sur une face active (101f) du premier substrat (101) ;
former un dispositif logique dans un deuxième substrat (160) d'une deuxième puce semi-conductrice (CH2), et former une deuxième couche d'interconnexion (170) sur une face active du deuxième substrat (160) ;
connecter la première puce semi-conductrice (CH1) et la deuxième puce semi-conductrice (CH2) l'une à l'autre de sorte que la première couche d'interconnexion (130) fasse face à la deuxième couche d'interconnexion (170) ;
retirer une partie du premier substrat (101) du côté de la face inactive (101b) ;
former une couche antireflet (110) présentant un premier indice de réfraction sur la face inactive (101b) du premier substrat (101) ;
former des vias traversants (BVS) dans une zone périphérique (PE) du premier substrat (101), la zone périphérique (PE) étant adjacente à la zone de pixels (PA ; 100) du premier substrat (101) ;
former des filtres de couleur (CF1, CF2), correspondant respectivement à la pluralité de pixels, sur la couche antireflet (110) de la zone de pixels (PA ; 100) ; et
former des microlentilles (ML) respectivement sur les filtres de couleur (CF1, CF2),
dans lequel la formation des filtres de couleur (CF1, CF2) comprend :
former un motif de grille sans métal (120), présentant une forme de grille bidimensionnelle, dans la zone de pixels (PA ; 100) ; et
former les filtres de couleur (CF1, CF2) respectivement dans des mailles du
motif de grille sans métal (120),
dans lequel le motif de grille sans métal (120) comprend une seule couche isolante présentant un deuxième indice de réfraction inférieur au premier indice de réfraction, et
**caractérisé en ce que** la couche antireflet (110) comprend une couche de TiO₂ (114) qui est interrompue dans une zone d'isolement de nœud (NDA).

10. Procédé selon la revendication 9, dans lequel la couche antireflet (110) comprend en outre une couche d'AlO (112) située sous la couche de TiO₂ (114), ainsi qu'une couche de tétraéthylorthosilicate, TEOS, et une couche de HfOx (L4 ; 118) situées au-dessus de la couche de TiO₂ (114), et
dans lequel la couche de HfOx (L4 ; 118) fonctionne comme couche d'arrêt de gravure lorsque la seule couche isolante est structurée.

11. Procédé selon la revendication 10, dans lequel, lors de la formation de la couche antireflet (110), la zone d'isolement de nœud (NDA), dans laquelle la couche de TiO₂ (114) est interrompue, est formée adjacente à :
chacun des contacts arrière (BCA) disposés linéairement à des intervalles prédéterminés adjacents à une portion périphérique de la zone de pixels (PA ; 100) ;
chacun de premiers vias traversants (BVS) disposés selon une structure en réseau bidimensionnel dans une portion de la zone périphérique (PE) ; et
chacun de seconds vias traversants (BVS) adjacents à, et sur au moins un côté de, chacun des plots métalliques (PAD) dans une portion périphérique de la zone périphérique (PE).

12. Procédé selon la revendication 11, dans lequel, dans la zone d'isolement de nœud (NDA), la couche d'AlO (112), la couche de TEOS et la couche de HfOx (L4 ; 118) s'étendent chacune de manière continue.
